# EUROPEAN PATENT SPECIFICATION

(11) **EP 2 938 177 B1**
(45) Date of publication and mention of the grant of the patent: **18.10.2017**
(21) Application number: 12890612.0
(22) Date of filing: 21.12.2012
(51) Int. Cl.: H05K 13/02

(54) **AUTOMATIC TAPE PROCESSING APPARATUS AND AUTOMATIC TAPE SETTING APPARATUS**
AUTOMATISCHE BANDVERARBEITUNGSVORRICHTUNG UND AUTOMATISCHE BANDEINSTELLUNGSVORRICHTUNG
APPAREIL DE TRAITEMENT DE BANDE AUTOMATIQUE ET APPAREIL DE RÉGLAGE DE BANDE AUTOMATIQUE

(43) Date of publication of application: 28.10.2015
(73) Proprietor: Fuji Machine Mfg. Co., Ltd., Chiryu-shi, Aichi 472-8686 (JP)
(72) Inventor: OTSUKI Takahiro, Chiryu-shi Aichi 472-8686 (JP)
(74) Representative: Grünecker Patent- und Rechtsanwälte PartG mbB
(86) International application number: PCT/JP2012/083279
(87) International publication number: WO 2014/097473

(56) References cited:
- JP-A- H0 717 511
- JP-A- 2002 187 210
- JP-A- 2004 091 039
- JP-A- 2004 091 039
- JP-A- 2005 152 521
- JP-A- 2005 152 521
- US-A1- 2003 219 330

## Description

### Technical Field

The present invention relates to an automatic tape processing apparatus that automatically processes a tip of a component packaging tape to be set to a tape feeder, and an automatic tape setting apparatus including the automatic tape processing apparatus.

### Background Art

A component mounting machine is used as an apparatus that mounts electronic components on a circuit board to produce an electronic circuit product. The component mounting machine is detachably mounted with a tape feeder having a tape reel on which a component packaging tape is wound. The component packaging tape has a configuration in which a top tape is attached to a carrier tape that accommodates the electronic components at predetermined intervals.

First, as a tape setting process, an operator sets the component packaging tape to the tape feeder. That is, the operator draws the component packaging tape out from the tape reel, and cuts the top tape and the carrier tape so that a tip of the top tape protrudes by a predetermined protrusion length with reference to a tip of the carrier tape. Further, the operator folds back the protruding portion of the top tape onto a rear surface side of the tip of the carrier tape, and holds the top tape in a first tape holder provided in the vicinity of a component supply position in the tape feeder. Then, the operator takes the separated top tape in the first tape holder along a predetermined transfer path, and holds the top tape in a second tape holder provided at a top tape discharge position in the tape feeder.

Next, as a component supply process, the tape feeder draws the component packaging tape out from the tape reel for conveyance, separates the top tape from the carrier tape, and supplies the electronic component accommodated in the carrier tape to the component supply position. Further, the tape feeder feeds the top tape separated from the carrier tape along the above-described transfer path for collection.

As described above, since the effort of the operator is necessary for setting the component packaging tape, it is desirable to shorten the time taken for setting the component packaging tape from the viewpoint of work efficiency. In this regard, for example, PTL 1 discloses an apparatus that automatically performs setting of a component packaging tape to a tape feeder. The apparatus disclosed in PTL 1 suctions a tip of a top tape by a suction pump and fixes the tip of the top tape to a winding reel by a heating roller.

The prior art in document JP 2005-152521 A (PTL 2) discloses a carrier tape cutting tool including a cutting edge positioning mechanism, wherein terminating treating or cut treating can be selected, and when cut treating is selected, a cut is formed in a base tape to cut only the base tape at the cut, and a cover tape can be projected from the base tape and cut to an arbitrary length.

The prior art in document JP 2004-091039 A (PTL 3) discloses a device having a first cutter, a second cuter, and a moving mechanism. The device adjusts the positions in which the first and second cutters are arranged in the direction of the thickness of carrier tape. The moving mechanism relatively moves the carrier tape, the first cutter, and the second cutter in a perpendicular direction. Thus, the leading end and the trailing end of the carrier tape can be processed in a shortened time.

The prior art in document US 2003/219330 A1 (PTL 4) discloses a method and an apparatus for the automatic loading and advancement of component feeder tape in a component feeder for use with a pick-and-place system. The feeder employs sensing technology to determine when a component tape leader is inserted into a tape guide, and subsequently auto-loads the feeder with the tape, including initiating the peeling of cover tape. Subsequently, the feeder operates to sense the presence of parts or components in the component tape pockets and to advance the component tape to a position where the first component is presented at the pick location. The feeder is also capable of detecting repeatable features in the component tape in order to automatically determine the component tape pitch.

### Citation List

### Patent Literature

PTL 1: JP 11-087991 A
PTL 2: JP 2005-152521 A
PTL 3: JP 2004-091039 A
PTL 4: US 2003/219330 A1

### Summary of Invention

### Technical Problem

However, in the apparatus disclosed in PTL 1, it is necessary that the operator performs the process of cutting the top tape and the carrier tape so that the tip of the top tape protrudes by the predetermined protrusion length with reference to the tip of the carrier tape, which causes the effort of the operator.

In order to solve the above problem, an object of the invention is to provide an automatic tape processing apparatus that automatically processes a tip of a component packaging tape to be set to a tape feeder, and an automatic tape setting apparatus including the automatic tape processing apparatus.

### Solution to Problem

According to claim 1, there is provided an automatic tape processing apparatus that automatically processes a component packaging tape which is wound on a tape reel mounted in a tape feeder and a top tape of which is attached on an upper surface side of a carrier tape having cavities accommodating a component at a predetermined pitch such that a tip of the top tape protrudes by a predetermined protrusion length with reference to a tip of the carrier tape, including: a feed device that conveys the component packaging tape along a conveyance path; a detection device that detects the presence or absence of the component accommodated in the cavity of the component packaging tape conveyed along the conveyance path at a detection position provided in the conveyance path; a separation device that separates the top tape from the component packaging tape conveyed along the conveyance path; a cutting device that cuts respective cutting target portions of the carrier tape and the top tape at a cutting position provided in the conveyance path; and a control device that controls respective operations of the feed device, the separation device, and the cutting device, in which the control device includes positioning control means for controlling the feed device and the separation device based on a detection signal from the detection device to sequentially position the respective cutting target portions of the carrier tape and the top tape at the cutting position, and cutting control means for controlling the cutting device to sequentially cut the respective cutting target portions of the carrier tape and the top tape.

With such a configuration, it is possible to automatically cut the top tape and the carrier tape so that the tip of the top tape protrudes by the predetermined protrusion length with reference to the tip of the carrier tape. Thus, it is not necessary to perform a tape cutting operation by an operator, and thus, it is possible to reduce a workload of the operator. Further, since the processes do not rely on the degree of skill of the operator, it is possible to improve efficiency when setting the component packaging tape to the tape feeder.

According to claim 2, the automatic tape processing apparatus further includes: a guide device that includes a pressing member that presses the component packaging tape conveyed along the conveyance path from a lower surface thereof, and a contact member with which an upper surface of the pressed component packaging tape is in contact, and guides the component packaging tape with reference to the upper surface when conveying the component packaging tape along the conveyance path.

With such a configuration, it is possible to convey the component packaging tape with high accuracy, and to enhance the cutting accuracy of the top tape and the carrier tape.

According to claim 3, the automatic tape processing apparatus further includes: a transfer device that holds the component packaging tape conveyed after cut by the cutting device and transfers the component packaging tape to an automatic tape loading device that automatically loads the component packaging tape to the tape feeder, and the control device includes holding control means for lowering the transfer device that is in a lifted state in advance, and causes the transfer device to hold the conveyed component packaging tape; and transfer control means for removing the component packaging tape from the conveyance path, causing the transfer device to move closer to the automatic tape loading device side so that a tape exiting port of the transfer device is aligned with a tape inserting port of the automatic tape loading device, and convey-supplying the component packaging tape from the tape exiting port to the tape inserting port for transfer.

With such a configuration, it is possible to automatically transfer the component packaging tape of which the tip is processed to the automatic tape loading device, to thereby further reduce the workload of the operator.

According to claim 4, in the automatic tape processing apparatus, the positioning control means causes, when the transfer device is lowered to convey the component packaging tape, a protruding portion of the top tape cut by the cutting device to protrude from the cutting position so that the protruding portion of the top tape is folded back onto a rear surface side of the tip of the carrier tape.

If the top tape protrudes from the carrier tape, there is a concern that the protruding portion of the top tape is entangled with the conveyance device or the like during conveyance of the component packaging tape. However, since the protruding portion of the top tape is folded back onto the rear surface side of the tip of the carrier tape, it is possible to smoothly convey the component packaging tape.

According to claim 5, in the automatic tape processing apparatus, the control device includes cutting target portion calculating means for calculating the cutting target portion of the carrier tape from a predetermined distance from the tip of the carrier tape to the component in the forefront and a distance between the detection position and the cutting position, based on a component presence signal transmitted when the detection device detects that the cavity where the component is not accommodated transitions to the cavity where the component is accommodated, and after the component presence signal is transmitted, the positioning control means conveys the component packaging tape by the distance between the detection position and the cutting position to position the cutting target portion of the carrier tape at the cutting position, and then, conveys the component packaging tape by the predetermined protrusion length of the top tape to position the cutting target portion of the top tape at the cutting position.

With such a configuration, even in the case of the component packaging tapes having different pitches between the cavities, it is possible to determine the cutting target portion, and to enhance the cutting accuracy of the top tape and the carrier tape.

According to claim 6, there is provided an automatic tape setting apparatus that automatically sets a component packaging tape to a tape feeder that separates a top tape from a carrier tape in a first tape holder and feeds the separated top tape from the first tape holder to a second tape holder along a predetermined transfer path, including: the automatic tape processing apparatus according to any one of claim 1 to claim 5, which automatically processes a tip of the top tape of the component packaging tape wound on a tape reel mounted in the tape feeder to protrude by a predetermined protrusion length with reference to a tip of the carrier tape; and an automatic tape loading device that conveys the component packaging tape that is processed and transferred by the automatic tape processing apparatus to the first tape holder, connects a tentative tape formed in a shape that resembles the transfer path to the top tape separated in the first tape holder, transfers the tentative tape to the tape feeder, and conveys the carrier tape from which the top tape is separated to a component supply position of the tape feeder.

With such a configuration, it is possible to automatically perform both of the processing of the tip of the component packaging tape and the setting of the component packaging tape to the tape feeder, and thus, it is possible to remarkably reduce the workload of the operator, and to set the component in a suppliable state in a short period of time.

According to claim 7, in the automatic tape setting apparatus, when the component packaging tape in which a protruding portion of the top tape is folded back onto a rear surface side of the tip of the carrier tape is transferred from the automatic tape processing apparatus, the automatic tape loading device conveys the component packaging tape to cause the protruding portion of the top tape to protrude from a tip portion of the tape feeder, and reversely conveys the component packaging tape to return the folded-back state of the protruding portion of the top tape to an original state.

With such a configuration, even though the protruding portion of the top tape is folded back onto the rear surface side of the tip of the carrier tape, since the folded-back state of the protruding portion of the top tape is returned to the original state in the tip portion of the tape feeder, it is possible to reliably separate the top tape from the carrier tape.

### Brief Description of Drawings

[Fig. 1] Fig. 1 is a plan view schematically illustrating an automatic tape setting apparatus according to an exemplary embodiment of the invention.
[Fig. 2] Fig. 2 is a perspective view schematically illustrating a tape feeder in which a component packaging tape is set.
[Fig. 3] Fig. 3 is an enlarged perspective view of a first tape holder in Fig. 2.
[Fig. 4] Fig. 4 is an enlarged perspective view of a second tape holder in Fig. 2.
[Fig. 5] Fig. 5 is a perspective view schematically illustrating the component packaging tape.
[Fig. 6] Fig. 6 is a perspective view schematically illustrating a feeder holding stand in Fig. 1.
[Fig. 7] Fig. 7 is a perspective view schematically illustrating an automatic tape processing apparatus in Fig. 1.
[Fig. 8] Fig. 8 is a side view schematically illustrating the automatic tape processing apparatus in Fig. 7.
[Fig. 9] Fig. 9 is a perspective view schematically illustrating a tape conveyance device, a first opening device, and a second opening device in Fig. 1.
[Fig. 10] Fig. 10 is a plan view schematically illustrating a top tape loading device in Fig. 1.
[Fig. 11] Fig. 11 is a plan view illustrating a positional relationship between the top tape loading device and the tape feeder.
[Fig. 12] Fig. 12 is an enlarged view illustrating a state where a tentative tape is held by plural pins when the tentative tape is transferred to the tape feeder in the top tape loading device.
[Fig. 13] Fig. 13 is an enlarged view illustrating a state where the tentative tape is transferred to a guide roller of a top tape feed guide when the tentative tape is transferred to the tape feeder in the top tape loading device.
[Fig. 14] Fig. 14 is a flowchart illustrating a tape processing process in the automatic tape processing apparatus.
[Fig. 15] Fig. 15 is a first diagram illustrating an operation of a path forming device in the top tape loading device.
[Fig. 16] Fig. 16 is a second diagram illustrating the operation of the path forming device in the top tape loading device.
[Fig. 17] Fig. 17 is a diagram schematically illustrating a component packaging tape inserting process in the tape processing process.
[Fig. 18] Fig. 18 is a diagram illustrating a cavity detecting process of a carrier tape in the tape processing process.
[Fig. 19] Fig. 19 is a diagram illustrating a top tape separating process in the tape processing process.
[Fig. 20] Fig. 20 is a diagram illustrating a positioning process of a cutting target portion of the carrier tape in the tape processing process.
[Fig. 21] Fig. 21 is a diagram illustrating a calculation process of the cutting target portion of the carrier tape in the tape processing process.
[Fig. 22] Fig. 22 is a diagram illustrating a cutting process of the carrier tape in the tape processing process.
[Fig. 23] Fig. 23 is a diagram illustrating a protruding process of a top tape in the tape processing process.
[Fig. 24] Fig. 24 is a diagram illustrating a positioning process of a cutting target portion of the top tape in the tape processing process.
[Fig. 25] Fig. 25 is a diagram illustrating a cutting process of the top tape in the tape processing process.
[Fig. 26] Fig. 26 is a first view illustrating a folding back process of the top tape in the tape processing process.
[Fig. 27] Fig. 27 is a second view illustrating the folding back process of the top tape in the tape processing process.
[Fig. 28] Fig. 28 is a diagram illustrating a transfer preparation process of the component packaging tape in the tape processing process.
[Fig. 29] Fig. 29 is a first diagram illustrating a transferring process of the component packaging tape in the tape processing process.
[Fig. 30] Fig. 30 is a second diagram illustrating the transferring process of the component packaging tape in the tape processing process.
[Fig. 31] Fig. 31 is a diagram illustrating a state where the automatic tape processing apparatus and the tape conveyance device move closer to the feeder holding stand in a tape loading process.
[Fig. 32] Fig. 32 is a perspective view illustrating a state where the component packaging tape is held in the first tape holder of the tape feeder in the tape loading process.
[Fig. 33] Fig. 33 is a diagram illustrating a state where the second opening device and the top tape loading device move closer to the feeder holding stand in the tape loading process.
[Fig. 34] Fig. 34 is a diagram illustrating a state of the top tape loading device in the tape loading process where parts of the tape feeder and the top tape loading device are shown in a see-through manner.
[Fig. 35] Fig. 35 is a diagram illustrating an operation of transferring the tentative tape to the tape feeder by the top tape loading device in the tape loading process.

### Description of Embodiments

### <Exemplary embodiments>

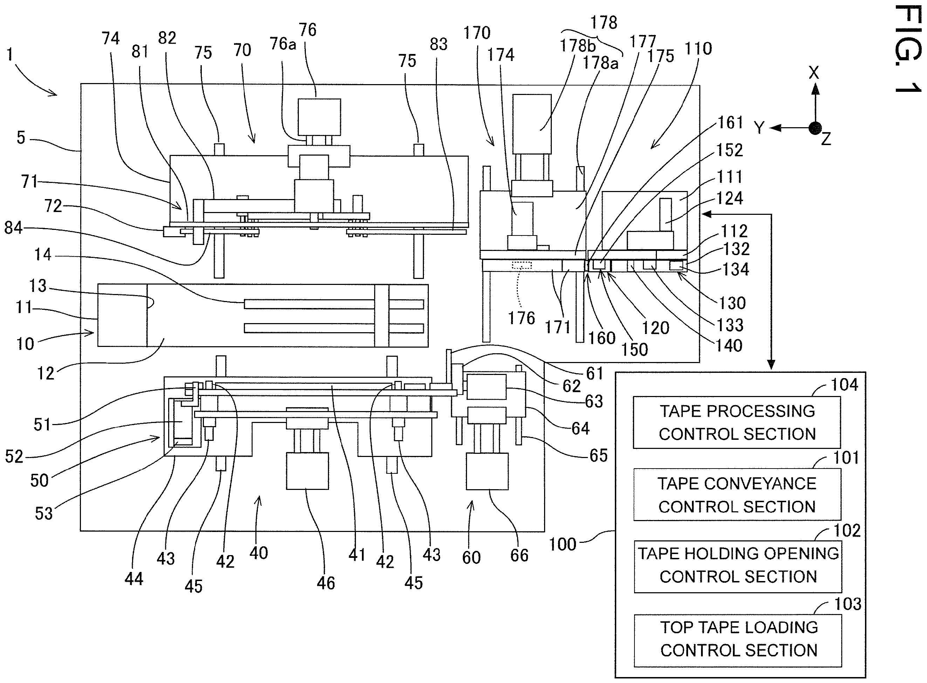

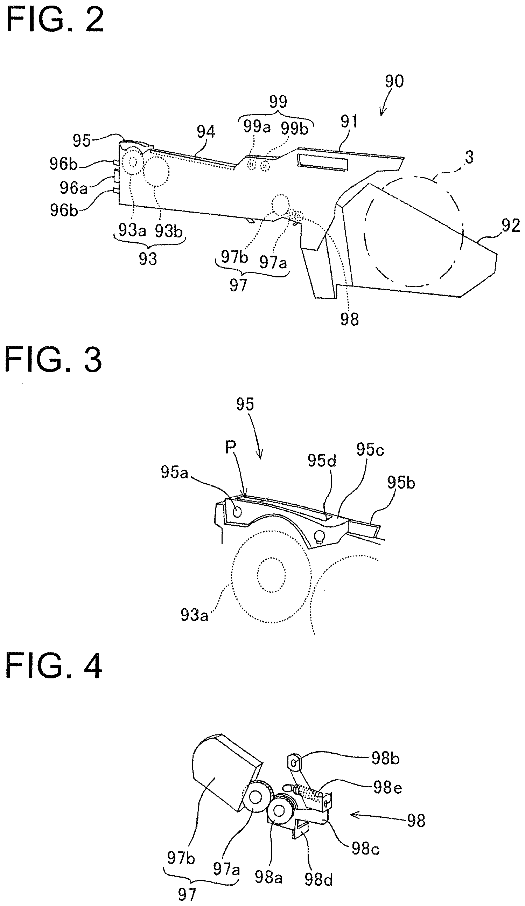

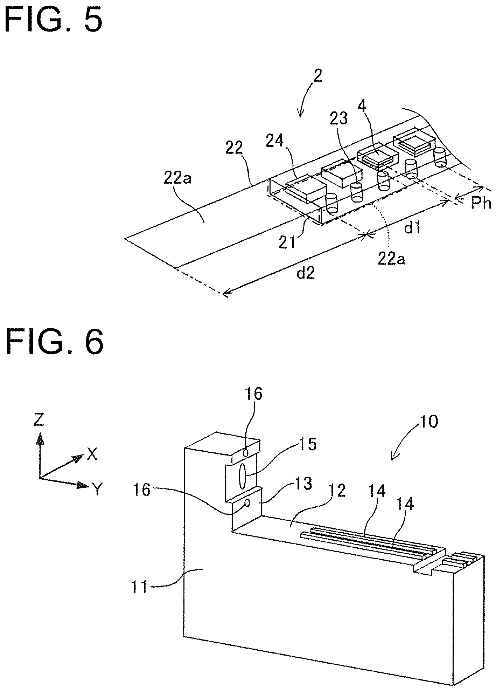

A configuration of an automatic tape setting apparatus according to an exemplary embodiment will be described with reference to the accompanying drawings. An automatic tape setting apparatus 1 shown in Fig. 1 is an apparatus that automatically sets a component packaging tape 2 shown in Fig. 5 to a tape feeder 90 shown in Fig. 2. More specifically, the automatic tape setting apparatus 1 is configured to process a tip of the component packaging tape 2 wound on a tape reel 3 to be set to the tape feeder 90, and then to draw the component packaging tape 2 out from the tape reel 3, to set the component packaging tape 2 to a pitch feed mechanism 93 of the tape feeder 90, to take a top tape 22 separated from a carrier tape 21 along a predetermined path, and to set the top tape 22 to a top tape feed mechanism 97.

In the following description, with reference to a tape conveying direction where the component packaging tape 2 is drawn out from the tape reel 3 when the component packaging tape 2 is set to the tape feeder 90, a horizontal direction perpendicular to the tape conveying direction is represented as an X-direction, a horizontal direction parallel to the tape conveying direction is represented as a Y-direction, and a vertical direction perpendicular to the X-direction and the Y-direction is represented as a Z-direction.

### (Configuration of tape feeder)

Here, the tape feeder 90 which is a target to which the component packaging tape 2 is set will be described. As shown in Fig. 2, on a rear end side (right side in Fig. 2) of a feeder main body 91 of the tape feeder 90, a reel housing 92 capable of accommodating the tape reel 3 on which the component packaging tape 2 is wound is provided. In an upper part on a front end side (left side in Fig. 2) of the feeder main body 91, the pitch feed mechanism 93 that pitch-feeds the component packaging tape 2 drawn out from the tape reel 3 is provided. Further, a tape feed guide 94 that forms a tape path for guiding the pitch-fed component packaging tape 2 is provided between the reel housing 92 and the pitch feed mechanism 93 in an upper surface portion of the feeder main body 91.

The pitch feed mechanism 93 includes a sprocket 93a, a motor 93b that rotationally drives the sprocket 93a, and the like. Further, a first tape holder 95 that holds the component packaging tape 2 so that the pitch-fed component packaging tape 2 does not deviate from the pitch feed mechanism 93 is provided in the pitch feed mechanism 93.

As shown in Fig. 3, the first tape holder 95 is provided with a rotation fulcrum 95a in a front end part thereof so that a rear end side thereof is movable in a diameter direction of the sprocket 93a. The first tape holder 95 is provided with a protruding lever 95b on the rear end side thereof, and is coupled with a coil spring (not shown) that contracts to downwardly pull a rear end part of the first tape holder 95. With such a configuration, the first tape holder 95 holds the component packaging tape 2 between the first tape holder 95 and the sprocket 93a in a normal state, and releases the tape holding in a state where the lever 95b is lifted up.

Further, an upper surface part 95c of the first tape holder 95 covers the component packaging tape 2, and has an opening on a front end side thereof as a component supply position P. The tape feeder 90 draws the top tape 22 toward the rear end side of the tape feeder 90 using a top tape separator 95d which is a rear end side edge of the opening in the upper surface part 95c of the first tape holder 95 as a fulcrum while holding the component packaging tape 2 by the first tape holder 95, to thereby separate the top tape 22 from the carrier tape 21.

As shown in Fig. 2, on a front end surface of the feeder main body 91, a communication connector 96a and two positioning pins 96b are provided. The communication connector 96a is connected to a communication jack 15 (see Fig. 6) of a feeder holding stand 10 to enable communication between a feeder controller of a control board (not shown) and a control device 100, and also functions as a power supply pin through which power is supplied to respective units of the tape feeder 90. Two positioning pins 96b are separately arranged in the vertical direction, and are used for determining holding positions with respect to the feeder holding stand 10 and a component mounting machine (not shown).

Further, the top tape feed mechanism 97 that feeds the top tape 22 separated by the top tape separator 95d in a direction opposite to the pitch feed direction of the component packaging tape 2 is provided in a lower central part of the feeder main body 91. The top tape feed mechanism 97 includes a gear 97a, a motor 97b that rotationally drives the gear 97a, and the like. Further, a second tape holder 98 that holds the top tape 22 so that the top tape 22 to be fed does not deviate from the top tape feed mechanism 97 is provided in the top tape feed mechanism 97.

As shown in Fig. 4, the second tape holder 98 is provided with a gear 98a capable of being engaged with the gear 97a of the top tape feed mechanism 97, an arm 98c having a fulcrum 98b that enables the gear 98a to move in the diameter direction of the gear 97a, a lever 98d that protrudes downward from the arm 98c, a coil spring 98e that contracts the arm 98c toward the gear 97a, and the like. With such a configuration, the second tape holder 98 engages the gear 98a with the gear 97a of the top tape feed mechanism 97 in a normal state to hold the top tape 22, and releases the tape holding in a state where the lever 98d is moved against an elastic force of the coil spring 98e.

A top tape feed guide 99 that guides the top tape 22 separated by the top tape separator 95d toward the top tape feed mechanism 97 is provided between the top tape separator 95d of the feeder main body 91 and the top tape feed mechanism 97. The top tape feed guide 99 is a guide section configured by a pair of guide rollers 99a and 99b, and is provided to be disposed above the component packaging tape 2 that is pitch-fed on the tape feed guide 94. Further, one guide roller 99a disposed on a tip side of the tape feeder 90 is provided as a roller that gives tension to the top tape 22 in order to prevent loosening of the top tape 22.

Here, as shown in Fig. 5, the component packaging tape 2 includes the carrier tape 21 where a component 4 is accommodated in cavities 24 formed at a predetermined pitch, and the top tape 22 that is bonded on an upper surface of the carrier tape 21 and covers the components 4. At one edge of the component packaging tape 2 in a width direction thereof, component packaging tape feed holes 23 are formed at a predetermined pitch Ph. Thus, the component packaging tape 2 is configured so that teeth of the sprocket 93a are sequentially fitted into the component packaging tape feed holes 23 to be pitch-fed as the sprocket 93a of the pitch feed mechanism 93 rotates.

Further, when the component packaging tape 2 is drawn out from the tape reel 3 and is set to the tape feeder 90, the component packaging tape 2 is cut so that a tip of the top tape 22 protrudes from a tip of the carrier tape 21 by a predetermined protruding length, and as indicated by a single dot chain line in Fig. 5, a protruding portion 22a of the top tape 22 is folded back onto a rear surface side of the tip of the carrier tape 21. For example, the component packaging tape 2 is cut so that a distance d1 from the tip of the carrier tape 21 to the component 4 in the forefront is 20 mm, and so that a length d2 of the protruding portion 22a of the top tape 22 is 40 mm from the tip of the carrier tape 21.

When the component is supplied, the component packaging tape 2 is drawn out from the tape reel 3 and is held by the first tape holder 95, and the top tape 22 is separated from the carrier tape 21 by the top tape separator 95d. The separated top tape 22 is taken away from the first tape holder 95 to the second tape holder 98 on a transfer path along the pair of guide rollers 99a and 99b. Further, the tape feeder 90 pitch-feeds the carrier tape 21 to feed the top tape 22 along a predetermined transfer path by synchronously driving the motor 93b of the pitch feed mechanism 93 and the motor 97b of the top tape feed mechanism 97.

### (Configuration of automatic tape setting apparatus)

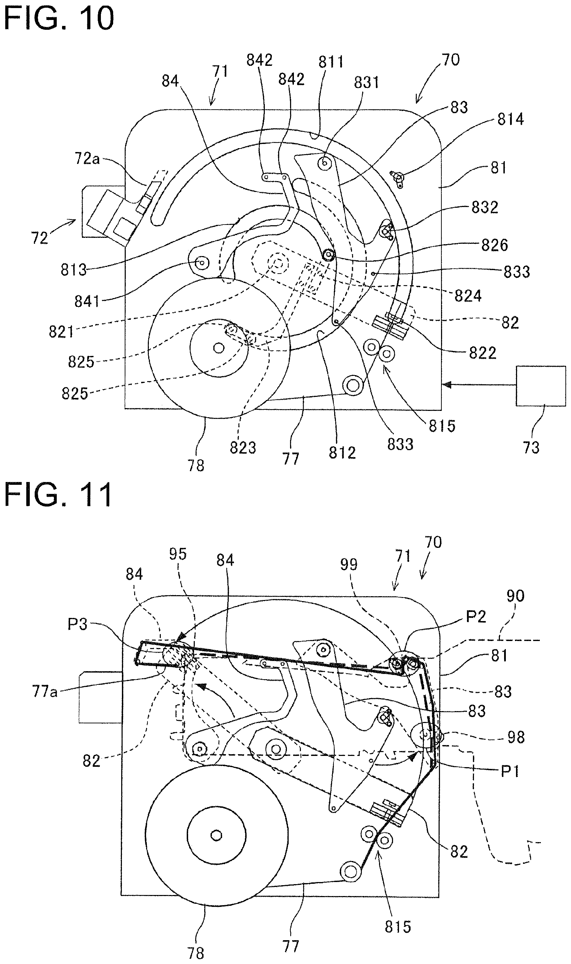

As shown in Fig. 1, the automatic tape setting apparatus 1 includes the feeder holding stand 10 that holds the tape feeder 90, an automatic tape processing apparatus 110 that processes a tip of the component packaging tape 2, a tape conveyance device 40 that conveys the component packaging tape 2 processed by the automatic tape processing apparatus 110, first and second opening devices 50 and 60 that release holding of the tape in the first and second tape holders 95 and 98 (see Fig. 2) of the tape feeder 90, a top tape loading device 70 that transfers a tentative tape 77 (see Fig. 10) to the tape feeder 90 to load the top tape 22, the control device 100 that controls operations of the respective devices, and the like. The feeder holding stand 10, the tape conveyance device 40, the first and second opening devices 50 and 60, and the top tape loading device 70 form an automatic tape loading device.

As shown in Fig. 1, the feeder holding stand 10 is disposed in a central portion on a base 5 so that a tape conveyance direction of the held tape feeder 90 is parallel to the Y-direction. As shown in Figs. 1 and 6, the feeder holding stand 10 includes a stand 11 that holds the tape feeder 90. The stand 11 is provided with a mounting section 12 on which a bottom face of the feeder main body 91 is mounted, and a contact section 13 with which a front end surface of the feeder main body 91 is in contact. A pair of support guides 14 with which lower side surfaces of the feeder main body 91 is interposed therebetween is provided on the mounting section 12. The communication jack 15 that is connected to the communication connector 96a of the tape feeder 90 to enable communication and power supply, and positioning holes 16 in which the two positioning pins 96b of the tape feeder 90 are inserted and positioned are provided in the contact section 13.

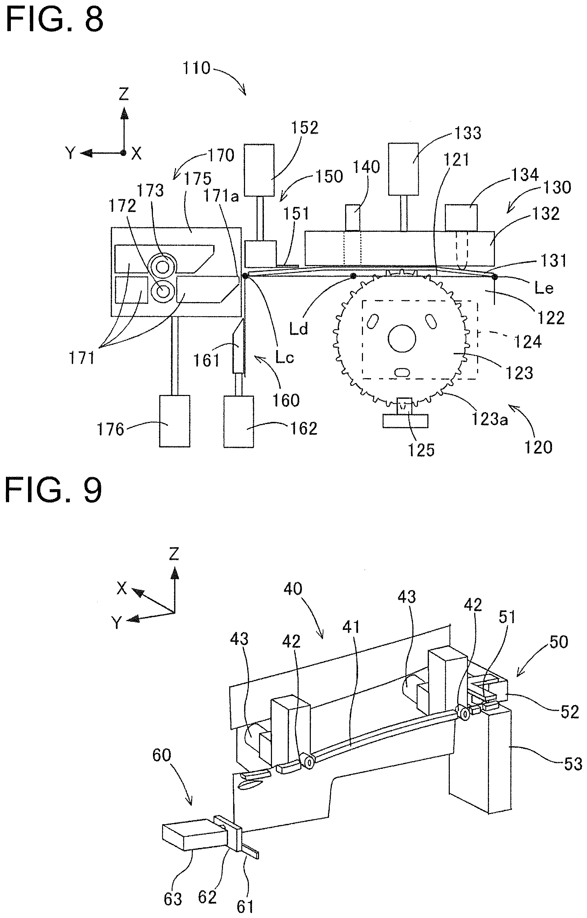

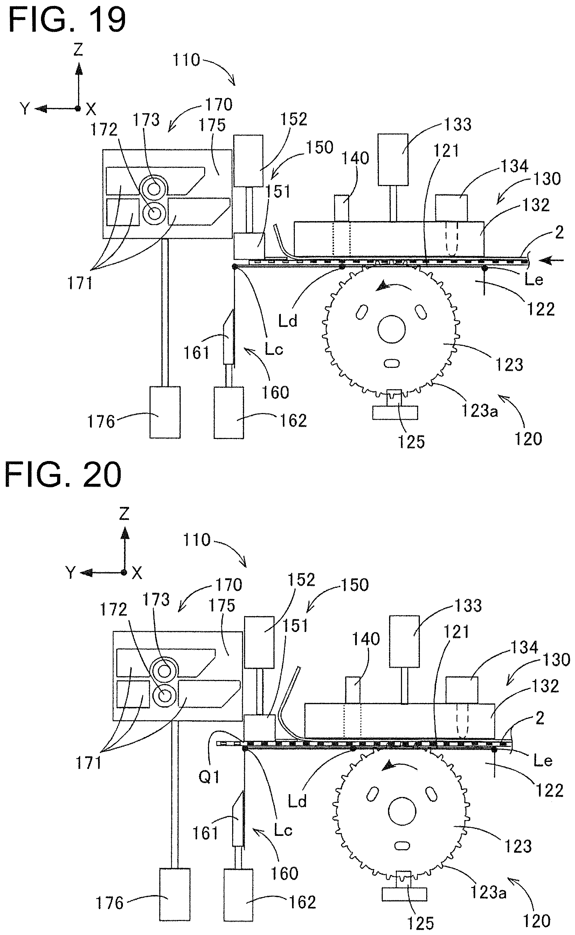

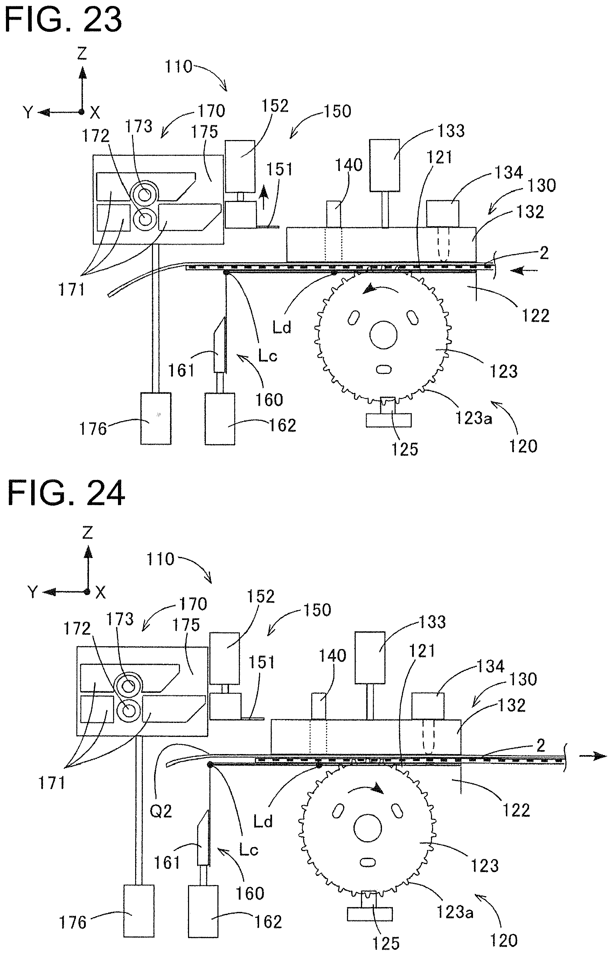

As shown in Fig. 1, the automatic tape processing apparatus 110 is disposed on the base 5 on a side where the tape feed guide 94 of the tape feeder 90 held on the feeder holding stand 10 is exposed (rear side of the tape feeder 90 shown in Fig. 2). As shown in Figs. 1, 7, and 8, the automatic tape processing apparatus 110 includes a feed device 120 that conveys (pitch-feeds) the component packaging tape 2 along a conveyance path 121, a guide device 130 that guides the component packaging tape 2 conveyed along the conveyance path 121, a detection device 140 that detects the cavities 24 of the component packaging tape 2 conveyed along the conveyance path 121 and the components 4 accommodated in the cavities 24 in a detection position Ld (see Fig. 8) provided in the conveyance path 121, a separation device 150 that separates the top tape 22 from the component packaging tape 2 conveyed along the conveyance path 121, a cutting device 160 that cuts respective cutting target portions Q1 (see Fig. 20) and Q2 (see Fig. 24) of the carrier tape 21 and the top tape 22 in a cutting position Lc (see Fig. 8) provided in the conveyance path 121, a transfer device 170 that transfers the component packaging tape 2 cut by the cutting device 160 to the tape conveyance device 40, and the like.

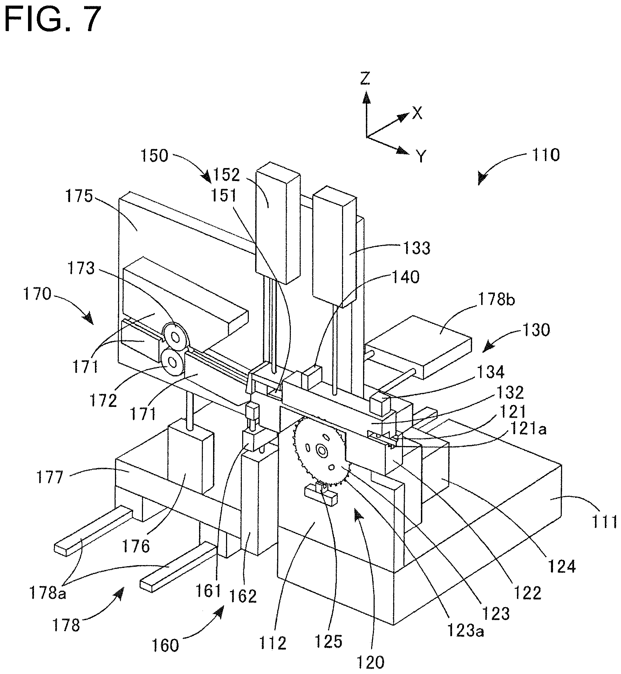

As shown in Figs. 7 and 8, the feed device 120 includes a sprocket 123 disposed under a conveyance member 122 in which the conveyance path 121 is provided, a gear motor 124 connected to the sprocket 123, a sprocket tooth detector 125 disposed in the vicinity of the sprocket 123, and the like. The feed device 120 conveys the component packaging tape 2 along the conveyance path 121 so that the cutting target portion Q1 of the carrier tape 21 and the cutting target portion Q2 of the top tape 22 can be sequentially positioned on the cutting position Lc.

The conveyance path 121 has a width slightly larger than the width of the component packaging tape 2, and is formed in a groove shape that linearly extends from a tape inlet Le (see Fig. 8) to the cutting position Lc in the conveyance member 122. Further, a fine groove 121a (see Fig. 7) for allowing passage of the cavity 24 where the component 4 is accommodated is formed in the conveyance path 121.

Plural teeth 123a having the same pitch as the pitch Ph of the feed holes 23 formed in the carrier tape 21 are formed in the sprocket 123 in a circumferential direction. The sprocket 123 is disposed under the conveyance path 121 so that a tooth 123a that reaches the highest rotational position among the rotating teeth 123a and the feed hole 23 of the component packaging tape 2 that is inserted along the conveyance path 121 are engaged with each other.

The gear motor 124 is a stepping motor, for example, and is a motor capable of controlling each position of the cutting target portions Q1 and Q2 of the carrier tape 21 and the top tape 22 of the component packaging tape 2 conveyed by the sprocket 123 that is connected thereto. The sprocket tooth detector 125 is a photo-sensor, for example, and is a sensor that detects that one of the teeth 123a of the sprocket 123 reaches a vertically upward position, that is, that the sprocket 123 is at an original position, by reading a mark attached to a side surface of the sprocket 123.

The guide device 130 is disposed above the feed device 120 and includes a pressing member 131 (see Fig. 8) which presses the component packaging tape 2 that is pitch-fed along the conveyance path 121 from a lower surface thereof, a contact member 132 with which an upper surface of the pressed component packaging tape 2 is in contact, an air cylinder 133 that moves up and down the contact member 132, a tape detection sensor 134 that detects the component packaging tape 2, and the like.

The pressing member 131 is a plate spring, for example, and is disposed in the fine groove 121a of the conveyance path 121. The contact member 132 is disposed to be in contact with or separated from the conveyance member 122 by the air cylinder 133. The tape detection sensor 134 is a touch sensor, for example, and is a sensor that detects that the component packaging tape 2 is inserted through the tape inlet Le in the conveyance member 122 by contact of the component packaging tape 2. The tape detection sensor 134 may be a photo-sensor instead of the touch sensor. The guide device 130 is configured, when the contact member 132 and the conveyance member 122 are in contact with each other, to guide the component packaging tape 2 with reference to the upper surface thereof when the component packaging tape 2 is conveyed along the conveyance path 121, and is configured, when the contact member 132 and the conveyance member 122 are separated from each other, to remove the component packaging tape 2 from the conveyance path 121.

As show in Figs. 1, 7, and 8, the detection device 140 is a photo-sensor, for example, and is a sensor that is disposed above the detection position Ld of the conveyance path 121 in the contact member 132 of the guide device 120 and detects the cavity 24 of the component packaging tape 2 conveyed along the conveyance path 121, a tape portion between the cavities 24, and the component 4 in the cavity 24 according to a change in light quantity. The detection device 140 may be a camera instead of the photo-sensor.

As shown in Figs. 7 and 8, the separation device 150 is disposed above the feed device 120 and includes a scraper 151 which separates the top tape 22 from the component packaging tape 2 conveyed along the conveyance path 121, an air cylinder 152 that moves up and down the scraper 151, and the like. The scraper 151 is provided with a blade edge capable of being inserted between the carrier tape 21 and the top tape 22 of the component packaging tape 2. The scraper 151 is positioned at a position where the scraper 151 is disposed between the carrier tape 21 and the top tape 22 of the component packaging tape 2 conveyed along the conveyance path 121, and at a position where the scraper 151 retracts upward, by the air cylinder 152.

As shown in Figs. 7 and 8, the cutting device 160 includes a cutter 161 provided at the cutting position Lc in the conveyance path 121, an air cylinder 162 that moves up and down the cutter 161, and the like. The cutter 161 is a single-edge cutter having a width larger than the width of the component packaging tape 2. The cutter 161 is disposed to move in the vertical direction by the air cylinder 162 in order to cut each of the cutting target portions Q1 and Q2 of the carrier tape 21 and the top tape 22 positioned at the cutting position Lc in the conveyance path 121.

As shown in Figs. 1 and 7, the above-described feed device 120, the guide device 130, the separation device 150, and the cutting device 160 are disposed on a supporting board 112 that is vertically fixed to a stand 111, and the stand 111 is disposed on the base 5 so that the conveyance path 121 is directed in the Y-direction.

As shown in Figs. 1, 7, and 8, the transfer device 170 includes guides 171 that guide the component packaging tape 2 that is cut by the cutting device 160 and is conveyed, a driving roller 172 that is disposed in the guides 171, a driven roller 173 that is disposed above the driving roller 172, a gear motor 174 (see Fig. 1) that rotationally drives the driving roller 172, an air cylinder 176 that moves up and down a supporting board 175 where the guides 171, the driving roller 172, the driven roller 173, and the gear motor 174 are arranged and supported, a stand 177 (see Figs. 1 and 7) where the air cylinder 176 is disposed and fixed, a moving device 178 (see Figs. 1 and 7) that includes a pair of rails 178a and an air cylinder 178b and that moves the stand 177 in the horizontal direction, and the like.

The guides 171 are disposed so that the driving roller 172 is interposed therebetween in the conveyance direction of the component packaging tape 2. The driven roller 173 is biased toward the driving roller 172 by a spring (not shown). The supporting board 175 is disposed to move in the vertical direction by the air cylinder 176 so as to position a tape conveyance port 171a (see Fig. 8) of the guide 171 at the cutting position Lc in the conveyance path 121 and the upper retraction position. The stand 177 is disposed to slide in the X-direction on the pair of rails 178a provided to extend in the X-direction on the base 5 with a predetermined interval. Further, the stand 177 is connected to the air cylinder 178b disposed between the pair of rails 178a on the base 5. The transfer device 170 is configured to hold the component packaging tape 2 conveyed after cut by the cutting device 160, and to transfer the component packaging tape 2 held in the automatic tape loading device to be automatically loaded to the tape feeder 90.

As shown in Fig. 1, the tape conveyance device 40 is disposed on the base 5 at a position which is diagonal with respect to the automatic tape processing apparatus 110 with the tape feeder 90 being held on the feeder holding stand 10 being interposed therebetween. As shown in Figs. 1 and 9, the tape conveyance device 40 includes guides 41 that guide the component packaging tape 2 to be conveyed, two driving rollers 42 disposed in the conveyance direction, two gear motors 43 that rotationally drive each driving roller 42, and the like. The guides 41 are respectively disposed in front of the driving roller 42 on a leading end side, between the two driving rollers 42, and in the back of the driving roller 42 on a trailing end side. The respective driving rollers 42 are arranged along with a predetermined interval in the Y-direction.

Further, as shown in Fig. 1, the tape conveyance device 40 is mounted and fixed to a stand 44 through a supporting board (not shown). The stand 44, a rail 45, and an air cylinder 46 of the tape conveyance device 40 respectively correspond to and are substantially the same as the stand 177, the rails 178a, and the air cylinder 178b of the transfer device 170, and thus, a detailed description thereof will not be repeated. Further, with such a configuration, the tape conveyance device 40 and the transfer device 170 are configured to be closer to or retracted from each other with the tape feeder 90 held in the feeder holding stand 10 being interposed therebetween in the X-direction.

Further, when the tape feeder 90 is held in the feeder holding stand 10 and the tape conveyance device 40 and the transfer device 170 move closer to the tape feeder 90, the component packaging tape 2 to be conveyed is guided through the guides 171 of the transfer device 170, and is guided through a gap between the guides 41 of the tape conveyance device 40 and the tape feed guide 94 of the tape feeder 90.

As shown in Fig. 1, the first and second opening devices 50 and 60 are disposed on the base 5 on opposite sides of the tape conveyance device 40 in the Y-direction. As shown in Figs. 1 and 9, the first opening device 50 includes a first lift lever 51 that is capable of moving the lever 95b (see Fig. 3) of the first tape holder 95 in the Z-direction, a support table 52 that supports a tip of the first lift lever 51 to protrude toward the tape feeder 90, an air cylinder 53 that is fixed on the stand 44 of the tape conveyance device 40 through a supporting board (not shown) to move the support table 52 in the Z-direction, and the like.

The second opening device 60 includes a second lift lever 61 that is capable of moving the lever 98d (see Fig. 4) of the second tape holder 98 in the Y-direction, a support table 62 that supports a tip of the second lift lever 61 to protrude toward the tape feeder 90, an air cylinder 63 that is capable of moving the support table 62 in the Y-direction, and the like. The air cylinder 63 is mounted and fixed to a stand 64 (see Fig. 1) through a supporting board (not shown).

The stand 64 of the second opening device 60 is mounted to slide in the X direction on one pair of rails 65 provided on the base 5 to extend in the X-direction with a predetermined interval. Further, the stand 64 is connected to a stand moving air cylinder 66. The stand moving air cylinder 66 is disposed between the pair of rails 65 on the base 5.

As shown in Fig. 1, the top tape loading device 70 is disposed on the base 5 on a side (rear side of the tape feeder 90 shown in Fig. 2) where the top tape feed mechanism 97 of the tape feeder 90 held on the feeder holding stand 10 is exposed. As shown in Figs. 1 and 10, the top tape loading device 70 includes a path forming device 71, a connecting device 72, a transfer control device 73, and the like.

As shown in Fig. 10, the path forming device 71 forms the tentative tape 77 in a shape that resembles the transfer path of the top tape 22, and holds the tentative tape 77. Here, the "tentative tape" refers to an extended tape in which a surrounding portion of the top tape 22 is formed in advance. In the present exemplary embodiment, the tentative tape 77 is formed in the same shape as that of the top tape 22, is formed of the same material as that of the top tape 22, and is wound on a tentative tape reel 78 to be held in the path forming device 71.

Further, the "transfer path" of the top tape 22 corresponds to a moving locus of the top tape 22 when the tape feeder 90 feeds the top tape 22 from the first tape holder 95 to the second tape holder 98. More specifically, a portion highlighted by a thick broken line in Fig. 11 represents the transfer path of the top tape 22 in the tape feeder 90. Further, the path forming device 71 forms the tentative tape 77 in a shape (thick solid line in Fig. 11) that resembles the transfer path of the top tape 22, that is, in a shape that approximately follows the corresponding transfer path.

As shown in Figs. 1 and 10, the path forming device 71 includes a main plate 81, a transfer section 82, a first extruding section 83, a second extruding section 84, and the like. The main plate 81 is a plate member having a rectangular shape as a general shape. As shown in Fig. 10, on the main plate 81, arc-shaped guide holes 811, 812, and 813 are concentrically formed. Further, an outside support pin mechanism 814 that supports the tentative tape 77 by being in contact therewith from the outside, and a pair of tentative tape support rollers 815 that guide and support the tentative tape 77 drawn out from the tentative tape reel 78 are disposed on a front surface of the main plate 81.

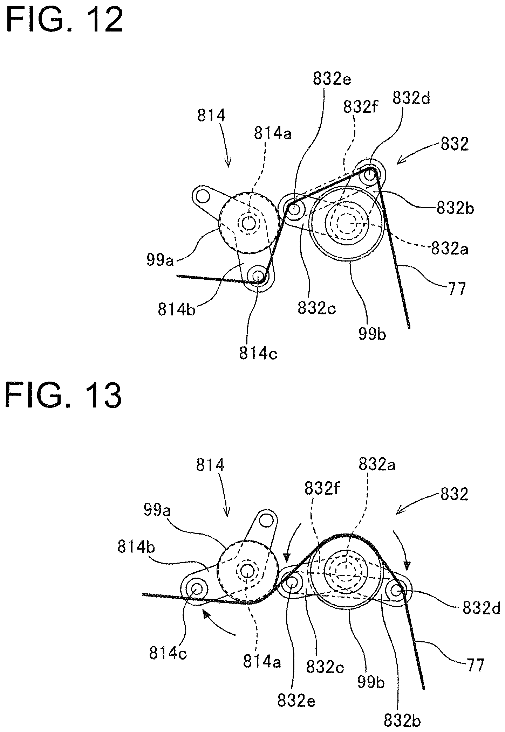

As shown in Fig. 12, in the outside support pin mechanism 814 of the main plate 81, a support plate 814b is rotatably provided on the main plate 81 by a rotation fulcrum 814a. A pin 814c for supporting the tentative tape 77 is provided in a tip portion of the support plate 814b to protrude in the X-direction.

As shown in Fig. 10, the transfer section 82 is disposed on a rear surface side of the main plate 81, and is rotatably supported at the center of the arc of the guide hole 811 by a rotation fulcrum 821. In a tip portion of the transfer section 82, a gripping claw 822 that is supported at an edge of the guide hole 811 circumferentially disposed on an outer side of the main plate 81 and is capable of gripping the tentative tape 77 on the front surface side of the main plate 81 is disposed.

Arms 823 and 824 that extend in a circumferential direction of the transfer section 82 are fixed between the rotation fulcrum 821 and the gripping claw 822 in the transfer section 82. In a tip portion of the arm 823 disposed on a lower side (lower side in Fig. 10) of the transfer section 82, two contact rollers 825 that are supported at the edge of the guide hole 812 disposed in the middle of the main plate 81 and that protrude on the front surface side of the main plate 81 are rotatably supported. Further, in a tip portion of the arm 824 disposed on an upper side (upper side in Fig. 10) of the transfer section 82, a contact roller 826 that is supported at the edge of the guide hole 813 circumferentially disposed on an inside of the main plate 81 and protrudes on the front surface side of the main plate 81 is rotatably supported.

With such a configuration, if the transfer section 82 is rotated by a driving motor (not shown), the transfer section 82 can transfer an end portion of the tentative tape 77 gripped by the gripping claw 822 along the guide hole 811. Further, if the transfer section 82 rotates from an initial angle to a predetermined transfer completion angle, as shown in Fig. 11, the transfer section 82 transfers the end portion of the tentative tape 77 to a third position P3, through a first position P1, and a second position P2 in the path forming device 71. Here, the first position P1 corresponds to the second tape holder 98, the second position P2 corresponds to the top tape feed guide 99, and the third position P3 corresponds to the first tape holder 95.

As shown in Fig. 10, the first extruding section 83 is disposed on the front surface side of the main plate 81, and is rotatably supported by a rotation fulcrum 831. The first extruding section 83 is biased in a clockwise direction around the rotation fulcrum 831 by an elastic member (not shown), and maintains a state of being in contact with the contact roller 826 of the transfer section 82 in an initial state. On the front surface of the first extruding section 83, an inside support pin mechanism 832 that supports the tentative tape 77 by being in contact therewith from the inside, and two guide pins 833 are disposed.

As shown in Fig. 12, in the inside support pin mechanism 832 of the first extruding section 83, two support plates 832b and 832c are provided to the first extruding section 83 to be rotatable by the rotation fulcrum 832a. At tip portions of the support plates 832b and 832c, pins 832d and 832e for supporting the tentative tape 77 are provided to protrude in the X-direction, and are rotatable around the rotation fulcrum 832a, respectively.

Further, the respective pins 832d and 832e are connected to an extension spring 832f through the respective support plates 832b and 832c, and maintain an initial interval by an elastic force of the extension spring 832f. In the present exemplary embodiment, as shown in Fig. 12, a distance between the respective pins 832d and 832e when the respective support plates 832b and 832c deviate to each other about 90 degrees is referred to as the initial interval.

As shown in Fig. 10, the second extruding section 84 is disposed on the front surface side of the main plate 81, and is rotatably supported by a rotation fulcrum 841. The second extruding section 84 is biased in a clockwise direction around the rotation fulcrum 841 by an elastic member (not shown), and in an initial state, maintains a state of a predetermined phase without being in contact with the respective contact rollers 825 and 826 of the transfer section 82. On the front surface of the second extruding section 84, two guide pins 842 that support the tentative tape 77 by being in contact therewith from the inside are disposed.

If the first extruding section 83 and the second extruding section 84 with such a configuration rotate when the transfer section 82 transfers the end portion of the tentative tape 77, as shown in Fig. 11, respective rear surface portions formed therein in a curved shape are in contact with the contact rollers 825 and 826 to rotate in a counterclockwise direction. Then, the inside support pin mechanism 832 and each guide pin 833 of the first extruding section 83, and each guide pin 842 of the second extruding section 84 are circumferentially moved to the outer side of the main plate 81.

In this way, the first extruding section 83 and the second extruding section 84 are configured to extrude a part of the tentative tape 77 drawn by transferring of the transfer section 82 in association with the rotation of the transfer section 82. Thus, the first extruding section 83 forms the tentative tape 77 in a shape that resembles the transfer path of the top tape 22. Further, the second extruding section 84 forms a facing surface 77a that faces the tip portion 22a of the top tape 22 in a portion where the tentative tape 77 is connected to the top tape 22.

As shown in Fig. 10, the connecting device 72 connects the tentative tape 77 held in the path forming device 71 to the top tape 22 separated from the carrier tape 21 in the first tape holder 95 of the tape feeder 90. The connecting device 72 is fixed to the main plate 81 of the path forming device 71. Further, in the present exemplary embodiment, the connecting device 72 heats the top tape 22 and the tentative tape 77 by a heating member 72a that obliquely extends upwards (right upward direction in the figure) to connect the top tape 22 and the tentative tape 77.

The transfer control device 73 is a device that transfers the tentative tape 77 connected to the top tape 22 from the path forming device 71 to the tape feeder 90. The transfer control device 73 controls the operation of the path forming device 71, and controls the operation of the second opening device 60 by communicating with the control device 100, to thereby transfer the tentative tape 77.

As shown in Fig. 1, in the top tape loading device 70, the path forming device 71 is mounted and fixed to a stand 74 through a supporting board (not shown), respectively. The stand 74 of the top tape loading device 70 is disposed to slide in the X-direction on one pair of rails 75 provided on the base 5 to extend in the X-direction with a predetermined interval. Further, the stand 74 is connected to an air cylinder 76. The air cylinder 76 is disposed between the pair of rails 75 on the base 5.

As shown in Fig. 1, the control device 100 includes a tape processing control section 104 that controls the operation of the automatic tape processing apparatus 110, a tape conveyance control section 101 that controls the operation of the tape conveyance device 40, a tape holding opening control section 102 that controls the operations of the first opening device 50 and the second opening device 60, a top tape loading control section 103 that controls the operation of the top tape loading device 70, and the like.

### (Operation of automatic tape setting apparatus)

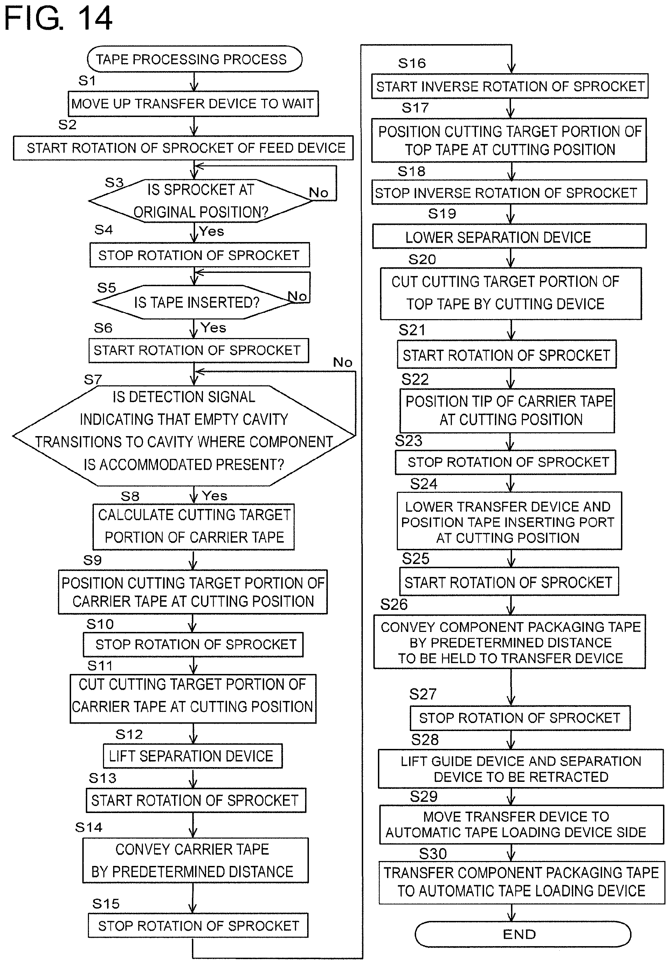

Next, the operation of the automatic tape setting apparatus 1 according to the present exemplary embodiment will be described with reference to a flowchart in Fig. 14, or the like. In the initial state of the automatic tape setting apparatus 1, as shown in Fig. 1, the entire transfer device 170, the tape conveyance device 40, the first and second opening devices 50 and 60, the top tape loading device 70 are separated from the feeder holding stand 10 in the X-direction with predetermined distances. Further, as shown in Fig. 8, the guide device 130, the separation device 150, the cutting device 160 and the transfer device 170 of the automatic tape processing apparatus 110 are in descending states.

Further, the top tape loading device 70 forms the tentative tape 77 in advance in a shape that resembles the transfer path of the top tape 22, and holds the tentative tape 77. That is, in the initial state of the top tape loading device 70 (in a state where the rotation angle of the transfer section 82 is 0 degree), as shown in Fig. 10, the gripping claw 822 of the transfer section 82 grips the end portion of the tentative tape 77 that protrudes from the pair of tentative tape support rollers 815, and the first and second extruding sections 83 and 84 maintain initial angles, respectively.

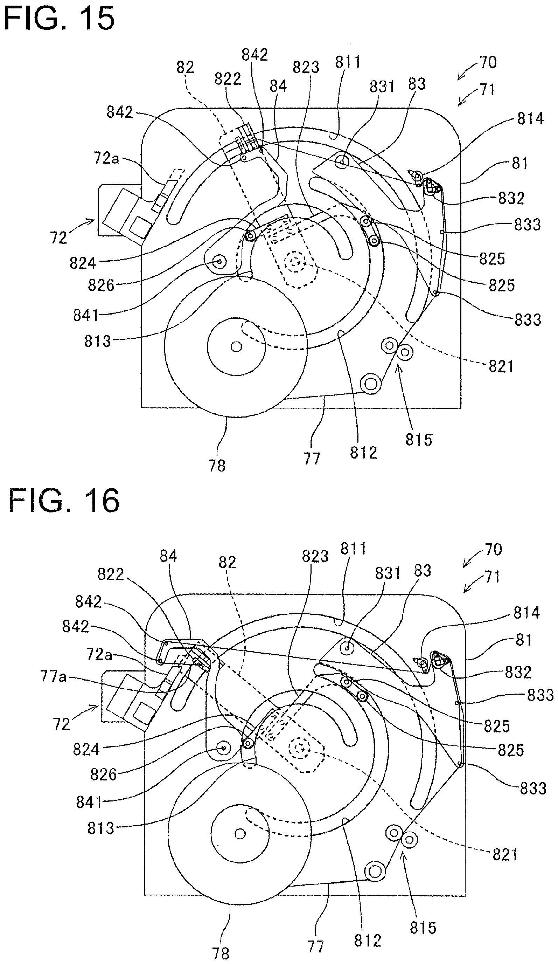

Further, if the transfer section 82 is rotationally driven, the tentative tape 77 is sequentially drawn out from the tentative tape reel 78, and the end portion of the tentative tape 77 is transferred through the first position P1 and the second position P2 using the pair of tentative tape support rollers 815 as a starting point. Further, if the transfer section 82 rotates by 140 degrees, as shown in Fig. 15, the contact rollers 825 and 826 of the transfer section 82 are in contact with the first extruding section 83 and the second extruding section 84, and cooperate with the first extruding section 83 and the second extruding section 84. Thus, the outside support pin mechanism 814 and the guide pins 833 of the first extruding section 83 gradually extrude the tentative tape 77. The second extruding section 84 moves in cooperation with the contact roller 826, but in this stage, is not in contact with the tentative tape 77.

Further, if the transfer section 82 is rotationally driven to rotate by 165 degrees from the initial state, as shown in Fig. 16, the end portion of the tentative tape 77 moves to the third position P3. Thus, the tentative tape 77 is drawn out to the position corresponding to the first tape holder 95 of the tape feeder 90 by the transfer section 82. Further, a part of the tentative tape 77 drawn by the transfer is further extruded by the first extruding section 83, and thus, the tentative tape 77 is formed in a shape that resembles the transfer path of the top tape 22.

More specifically, as shown in Fig. 12, the tentative tape 77 is formed in an S-curved shape by the outside support pin mechanism 814 of the main plate 81 and the inside support pin mechanism 832 of the first extruding section 83. Here, in the inside support pin mechanism 832, the respective pins 832d and 832e maintain the initial interval by the extension spring 832f.

In a state where the transfer section 82 rotates by 165 degrees from the initial state, as shown in Fig. 16, a part of the tentative tape 77 drawn by the transfer is extruded by the guide pins 842 of the second extruding section 84, and the tentative tape 77 is formed in a channel shape to face the top tape 22 when the tentative tape 77 is connected to the top tape 22 at a later time.

In this way, the top tape loading device 70 operates the first extruding section 83 and the second extruding section 84 in cooperation with each other by rotating the transfer section 82, to thereby form and hold the tentative tape 77 in a predetermined shape. Here, it is sufficient if the formation of the tentative tape 77 by the top tape loading device 70 is performed up to the loading of the top tape 22. For example, the formation of the tentative tape 77 may be performed in parallel with conveyance of the component packaging tape 2 to be described later.

In the above-described initial state, an operator sets the tape feeder 90 on the feeder holding stand 10. Specifically, the operator places a bottom face of the feeder main body 91 between the pair of support guides 14 on the mounting section 12 to be interposed therebetween, and inserts the positioning pins 96b and the communication connector 96a of the feeder main body 91 into the positioning holes 16 and the communication jack 15 of the contact section 13, respectively. Further, the operator mounts the tape reel 3 into the reel housing 92, and pushes a feeder setting completion button provided in the control device 100 of the automatic tape setting apparatus 1.

Then, the tape processing control device 104 moves up the supporting board 175 of the transfer device 170 to wait at the retraction position (step S1). Then, the tape processing control section 104 starts rotation of the sprocket 123 of the feed device 120 (step S2), and determines whether a detection signal is received from the sprocket tooth detector 125, that is, whether the sprocket 123 is at the original position (step S3). Then, if the detection signal is received from the sprocket tooth detector 125, the tape processing control section 104 stops the rotation of the sprocket 123 (step S4) .

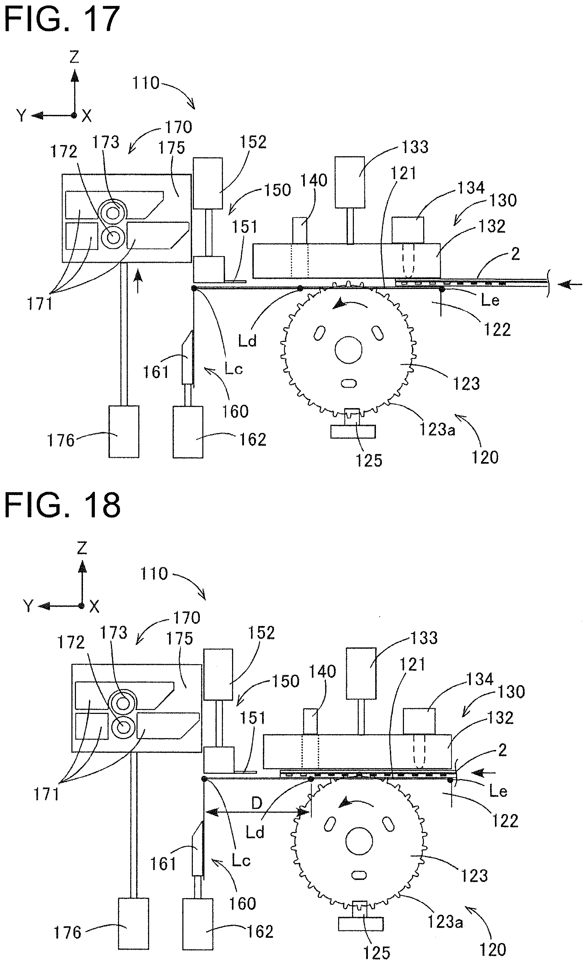

The tape processing control device 104 determines whether a detection signal is received from the tape detection sensor 134 of the guide device 130, that is, whether the tip portion of the component packaging tape 2 is inserted into the conveyance path 121 of the conveyance member 122 through the tape inlet Le by the operator (step S5). Further, as shown in Fig. 17, if the detection signal is received from the tape detection sensor 134, the tape processing control device 104 starts the rotation of the sprocket 123 (step S6).

The tape processing control device 104 determines whether a detection signal indicating that an empty cavity 24 transitions to a cavity 24 where the component 4 is accommodated is received from the detection device 140 (step S7). Further, as shown in Fig. 18, if it is detected that the empty cavity 24 transitions to the cavity 24 where the component 4 is accommodated, the tape processing control device 104 calculates the cutting target portion Q1 of the carrier tape 21 from the distance d1 from the tip of the carrier tape 21 to the component 4 in the forefront which is set in advance and a distance D between the known detection position Ld and the cutting position Lc (step S8, corresponding to "cutting target portion calculating means").

As shown in Fig. 19, the tape processing control device 104 continuously conveys the component packaging tape 2 to separate the top tape 22 from the carrier tape 21 by the scraper 151 of the separation device 150. The separated top tape 22 temporarily remains above the separation device 150. Further, as shown in Fig. 20, the tape processing control device 104 further conveys the component packaging tape 2 to position and convey the cutting target portion Q1 of the carrier tape 21 by the cutting position Lc (step S9), and stops the rotation of the sprocket 123 (step S10).

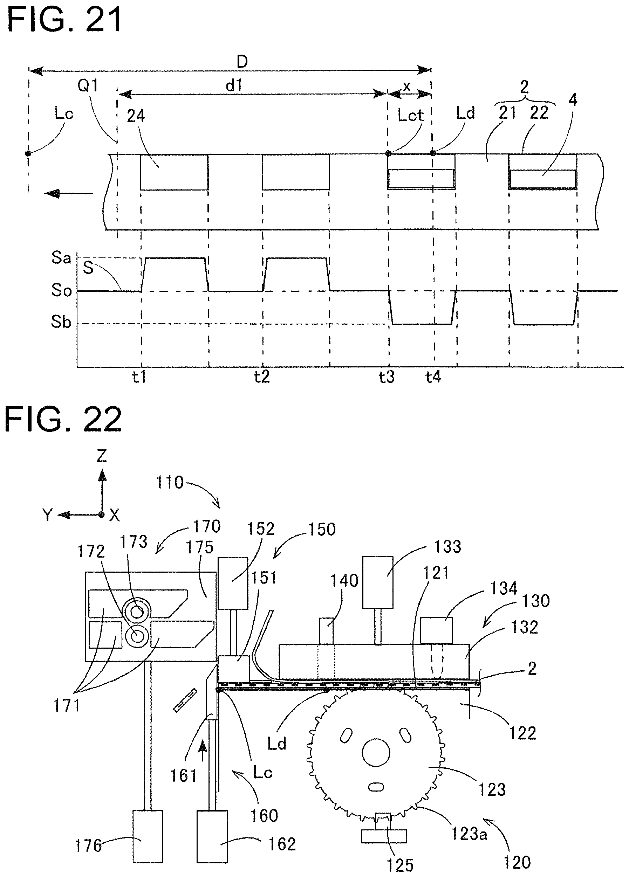

Here, an example of the processes of the above-described steps S7 to S10 will be described in detail. As shown in Fig. 21, when a detection signal (light intensity) S from the detection device 140 is So in a tape portion between the cavities 24 of the component packaging tape 2, the detection signal S becomes Sa in the cavity 24 where the component 4 is not accommodated since the transmission light intensity increases, and becomes Sb in the cavity 24 where the component 4 is accommodated since the transmission light intensity decreases.

Thus, after the empty cavity 24 transitions to the cavity 24 where the component 4 is accommodated, the number of pulses of the gear motor 124 for the sprocket 123 between a rising time point t3 of the detection signal S and a current time point t4 is counted. Further, by calculating the amount of feed of the component packaging tape 2 based on the number of pulses counted, it is possible to calculate a distance x between a position Lct of a left end (in the figure) of the cavity 24 where the component 4 is accommodated and the detection position Ld.

In addition, by conveying the component packaging tape 2 by a distance D-d1-x obtained by subtracting the distance d1 from the tip of the carrier tape 21 to the component 4 in the forefront which is set in advance and the distance x from the distance D between the known detection position Ld and the cutting position Lc, it is possible to position the cutting target portion Q1 at the cutting position Lc. Alternatively, by reversely conveying the component packaging tape 2 by the distance d1+x and then conveying the component packaging tape 2 by the distance D, it is possible to position the cutting target portion Q1 of the carrier tape 21 at the cutting position Lc.

As shown in Fig. 22, the tape processing control device 104 moves up the cutter 161 of the cutting device 160 to cut the cutting target portion Q1 of the carrier tape 21 which is positioned at the cutting position Lc (step S11). Further, as shown in Fig. 23, the tape processing control device 104 lifts the scraper 151 to wait at the standby position (step S12), starts the rotation of the sprocket 123 (step S13), conveys the carrier tape 21 by a predetermined distance (step S14) to feed the top tape 22 that temporarily remains above the separation device 150 in front of the carrier tape 21, and stops the rotation of the sprocket 123 (step S15).

As shown in Fig. 24, the tape processing control device 104 starts inverse rotation of the sprocket 123 (step S16), calculates the cutting target portion Q2 of the top tape 22 to be positioned at the cutting position Lc so that the top tape 22 protrudes from the tip of the carrier tape 21 cut in step S11 by a predetermined length d1 (step S17), and stops the inverse rotation of the sprocket 123 (step S18).

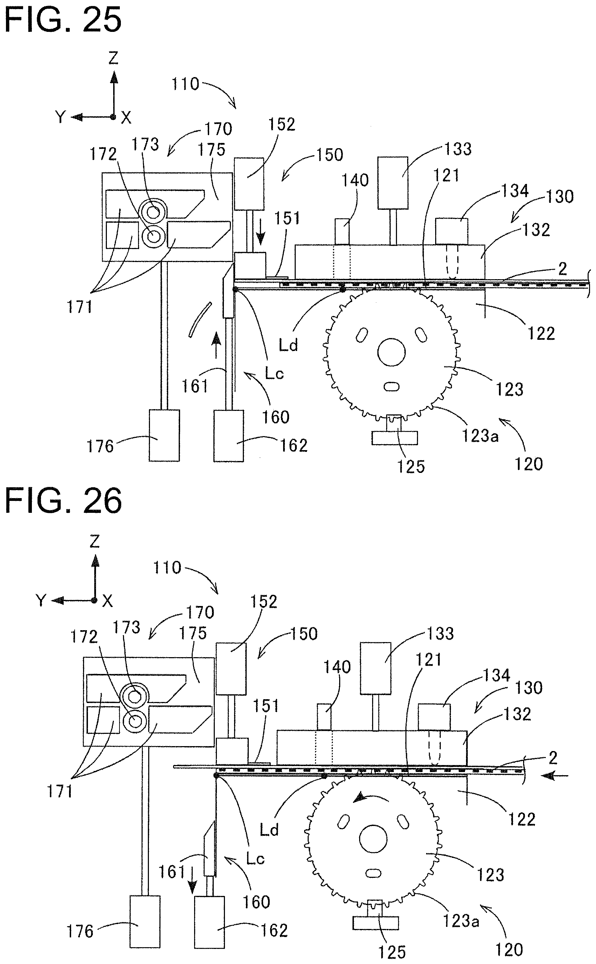

As shown in Fig. 25, the tape processing control device 104 lowers the separation device 150 (step S19), and lifts the cutter 161 of the cutting device 160 to cut the cutting target portion Q2 of the top tape 22 positioned at the cutting position Lc (step S20). Further, as shown in Fig. 26, the tape processing control device 104 starts the rotation of the sprocket 123 (step S21), positions the tip of the carrier tape 21 at the cutting position Lc (step S22), and stops the rotation of the sprocket 123 (step S23).

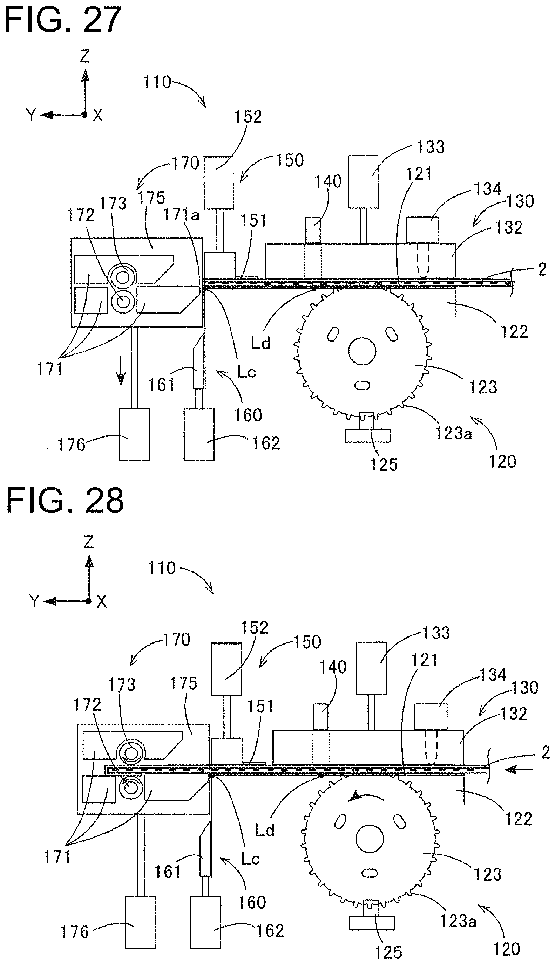

As shown in Fig. 27, the tape processing control device 104 lowers the supporting board 175 of the transfer device 170, and positions the tape conveyance port 171a of the guide 171 at the cutting position Lc of the conveyance path 121 (step S24). Here, the carrier tape 21 that protrudes from the cutting position Lc is pressed by the guide 171 to be suspended downward. Further, as shown in Fig. 28, the tape processing control device 104 starts the rotation of the sprocket 123 (step S25), conveys the component packaging tape 2 along the guides 171 to be held between the driving roller 172 and the driven roller 173 (step S26), and then, stops the rotation of the sprocket 123 (step S27).

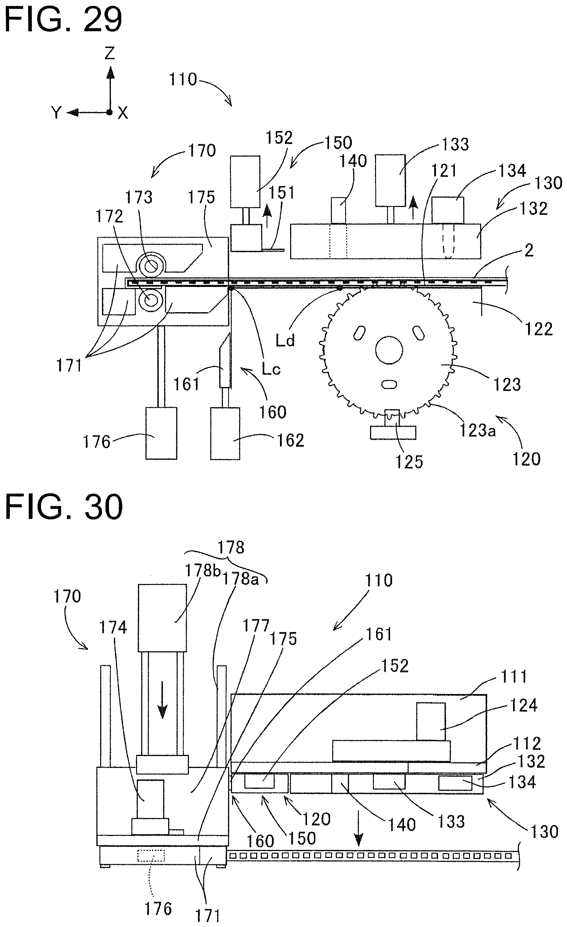

As shown in Fig. 29, the tape processing control device 104 lifts the contact member 132 of the guide device 130 and the scraper 151 of the separation device 150 to be retracted (step S28), and as shown in Fig. 30, moves the stand 177 of the transfer device 170 in the X-direction to be closer to the feeder holding stand 10 (step S29). Thus, the component packaging tape 2 held between the driving roller 172 and the driven roller 173 is removed from the conveyance path 121, and moves in the X-direction to be closer to the feeder holding stand 10.

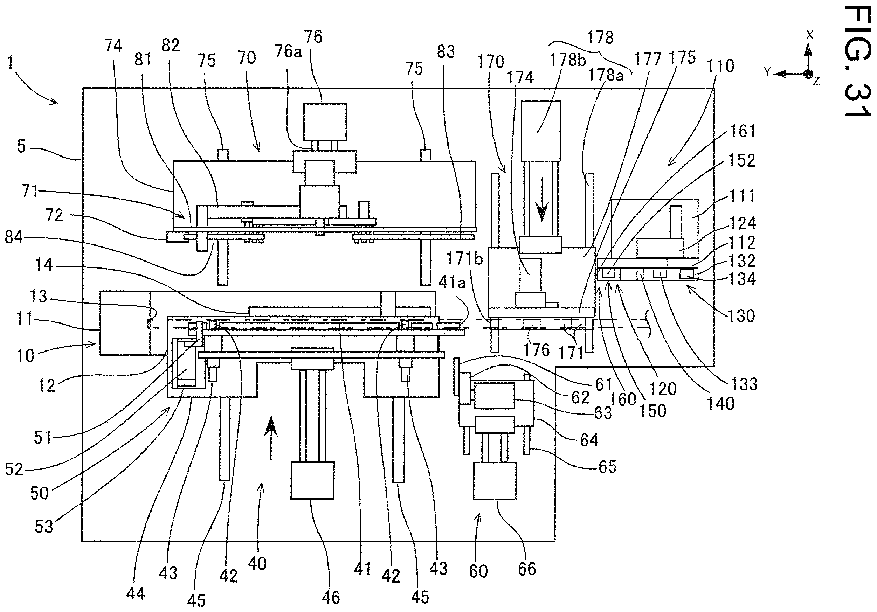

On the other hand, the tape conveyance control section 101 moves the tape conveyance device 40 in the X-direction to be closer to the feeder holding stand 10. Further, as shown in Fig. 31, the transfer device 170 and the tape conveyance device 40 are positioned so that a tape exiting port 171b in the guide 171 and a tape inserting port 41a in the guide 41 are aligned, that is, so that the respective X-directional positions of the guides 171 and 41 are the same as the X-directional position of the tape feed guide 94 of the tape feeder 90.

Further, the first opening device 50 also moves according to the movement of the tape conveyance device 40, and the first lift lever 51 of the first opening device 50 is inserted into an operation side of the lever 95b of the first tape holder 95 of the tape feeder 90. Further, the tape holding opening control section 102 lifts the support table 52 of the first opening device 50 in the Z-direction, and lifts the lever 95b of the first tape holder 95 by the first lift lever 51. Thus, the first tape holder 95 rotates upward around the rotation fulcrum 95a, and thus, the holding state of the pitch feed mechanism 93 is released.

Further, the tape processing control device 104 drives the gear motor 174 of the transfer device 170, and the tape conveyance control section 101 drives the motor 93b. Thus, the component packaging tape 2 is fed by the respective driving rollers 172 and 42, is guided by the guides 171 and 41 and the tape feed guide 94, and is conveyed through the gap between the first tape holder 95 and the pitch feed mechanism 93. Through the above-described processes, the transfer of the component packaging tape 2 to the automatic tape loading device is completed (step S30).

The tape holding opening control section 102 lowers the support table 52 of the first opening device 50 and the first lift lever 51. Thus, the first tape holder 95 rotates downward around the rotation fulcrum 95a, and thus, the first tape holder 95 holds the component packaging tape 2 between the first tape holder 95 and the pitch feed mechanism 93. Further, the tape conveyance control section 101 drives the motor 93b to rotate the sprocket 93a, to thereby convey the component packaging tape 2 so that the component packaging tape 2 protrudes from the first tape holder 95 by a predetermined amount.

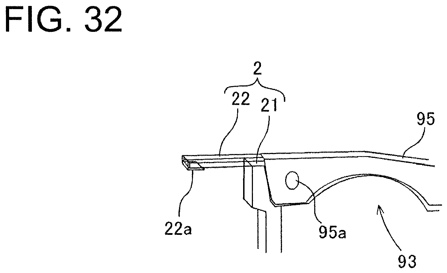

Here, as shown in Fig. 32, in the case of the component packaging tape 2 where the protruding portion 22a of the top tape 22 is folded back onto the rear surface side of the tip of the carrier tape 21, the tape conveyance control section 101 reversely conveys the component packaging tape 2 to return the folded-back state of the protruding portion 22a of the top tape 22 to an original state. Further, the tape conveyance control section 101 conveys the component packaging tape 2 again so that the component packaging tape 2 protrudes from the first tape holder 95 by a predetermined amount. Thus, since the protruding portion 22a of the top tape 22 protrudes from the tip of the carrier tape 21, it is possible to reliably separate the top tape 22 from the carrier tape 21.

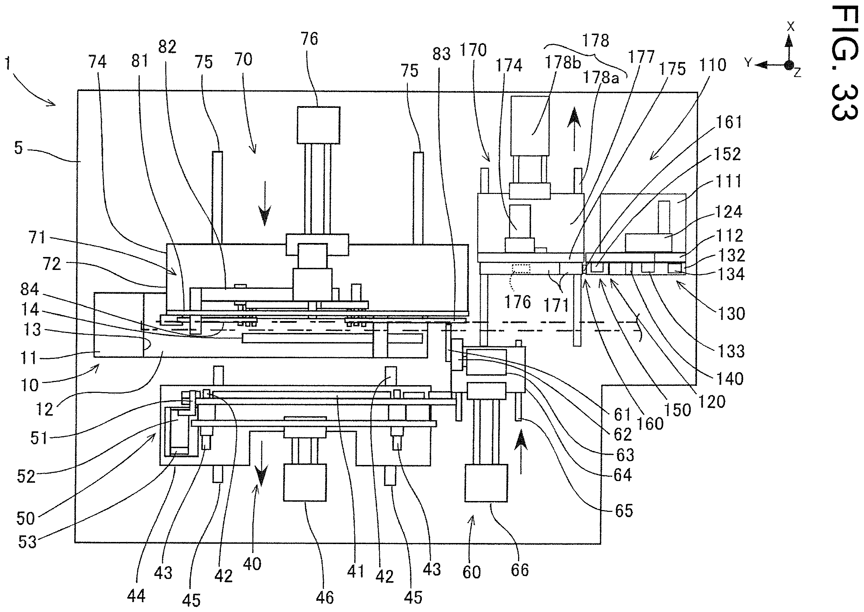

Subsequently, as shown in Fig. 33, the tape conveyance control section 101 moves the tape conveyance device 40 in the X-direction to be separated from the feeder holding stand 10. Further, the tape holding opening control section 102 moves the second opening device 60 in the X-direction to be closer to the feeder holding stand 10. Thus, the second lift lever of the second opening device 60 is inserted into the operation side of the lever 98d of the second tape holder 98 of the tape feeder 90.

Further, the tape holding opening control section 102 moves the support table 62 of the second opening device 60 in the γ-direction to rotate the arm 98c of the second tape holder 98 by the second lift lever 61 around the rotation fulcrum 98b on the rear end side of the feeder main body 91. Thus, the gear 98a of the second tape holder 98 is spaced away from the gear 97a of the top tape feed mechanism 97, and thus, the holding state with respect to the top tape feed mechanism 97 is released.

In this way, in the state where the second tape holder 98 is opened, the top tape loading control section 103 moves the top tape loading device 70 in the X-direction to be closer to the feeder holding stand 10. Here, the top tape loading device 70 is in a state where the tentative tape 77 is formed in advance in a shape that resembles the transfer path of the top tape 22 to be held, as described above. Further, as shown in Fig. 33, the top tape loading device 70 is positioned so that the X-directional position of the tentative tape 77 to be held is the same as the X-directional position of the component packaging tape 2 held by the tape feeder 90.

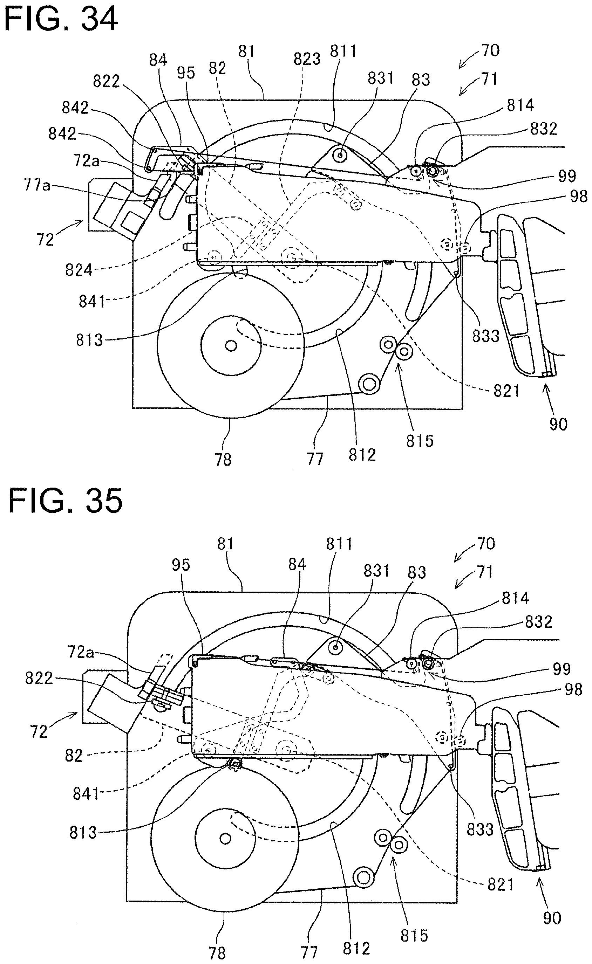

Then, as shown in Fig. 34, the end portion of the tentative tape 77 is positioned under the top tape 22 that protrudes from the first tape holder 95, so that the facing surface 77a of the tentative tape 77 faces the tip end portion 22a of the top tape 22. Further, a portion of the tentative tape 77 that is positioned between the two guide pins 833 of the first extruding section 83 is positioned to pass between the gear 97a of the top tape feed mechanism 97 and the gear 98a of the second tape holder 98 that are spaced away from each other. Further, a portion of the tentative tape 77 that is curved in an S-shape by the outside support pin mechanism 814 and the inside support pin mechanism 832 is positioned to pass through between two guide rollers 99a and 99b of the top tape feed guide 99 in the tape feeder 90, as shown in the figure.

Further, the top tape loading control section 103 heats the top tape 22 and the tentative tape 77 that face each other while disposing the top tape 22 and the tentative tape 77 between the heating member 72a and a tape retainer (not shown) by the connecting device 72. Then, an adhesive that remains on the separation surface of the top tape 22 separated from the carrier tape 21 is softened by the heating to function as an adhesive again. Thus, the tentative tape 77 is connected to the top tape 22. Further, the top tape loading control section 103 controls the gripping claw 822 of the transfer section 82 to release the gripping of the tentative tape 77.

Then, the transfer control device 73 controls the operations of the path forming device 71 and the second opening device 60 to transfer the tentative tape 77 held by the path forming device 71 to the tape feeder 90. Specifically, the transfer control device 73 further rotates the transfer section 82 of the path forming device 71 in the counterclockwise direction. Then, the contact roller 826 of the transfer section 82 is separated from a rear surface portion of the second extruding section 84, and the second extruding section 84 is rotated by the elastic member in the clockwise direction to return to the initial state.

Then, as shown in Fig. 35, the tentative tape 77 together with the connected top tape 22 is supported by the pin 814c of the outside support pin mechanism 814 from the first tape holder 95. Subsequently, a tension applying section 73a of the transfer control device 73 reversely rotates the tentative tape reel 78 (in the clockwise direction). Thus, the tentative tape 77 that becomes loose as the second extruding section 84 returns to the initial position is wound.

Further, if the tension applying section 73a rotates the tentative tape reel 78 when the pitch feed mechanism 93 of the tape feeder 90 is stopped, the tension of the tentative tape 77 increases. Then, as shown in Fig. 13, the two pins 832d and 832e are expanded against the elastic force of the extension spring 832f of the inside support pin mechanism 832, and pass through both sides of the guide roller 99b of the tape feeder 90.

In this way, the tentative tape 77 which is held by the two pins 832d and 832e is transferred to the guide roller 99b. Similarly, the pin 814c of the outside support pin mechanism 814 also moves to the tip side of the tape feeder 90, and the tentative tape 77 which is held by the pin 814c is transferred to the guide roller 99a of the tape feeder 90.

Finally, the transfer control device 73 sends a control signal to the tape holding opening control section 102 so that the second opening device 60 enters the holding state. Thus, the tape holding opening control section 102 moves the support table 62 of the second opening device 60 in the γ-direction to rotate the arm 98c of the second tape holder 98 around the rotation fulcrum 98b toward the front end side of the feeder main body 91. Thus, the tentative tape 77 is held between the gear 98a of the second tape holder 98 and the gear 97a of the top tape feed mechanism 97.

Further, the top tape loading device 70 cuts the tentative tape 77 between the second tape holder 98 and the tentative tape reel 78 by a tape cutter (not shown). Then, the top tape loading device 70 is moved in the X-direction to be spaced away from the feeder holding stand 10 by the top tape loading control section 103. In this way, the tentative tape 77 is transferred to the tape feeder 90 as shown in the figure. Here, the tentative tape 77 intersects the component packaging tape 2 during conveyance, but is locked to a notch 91a provided in the feeder main body 91 over the component packaging tape 2, and thus, interference with the component packaging tape 2 is prevented.

Further, the tape conveyance control section 101 drives the motor 93b to rotate the sprocket 93a so that setting of the position of a leading one of the components 4 accommodated in the carrier tape 21 is performed, that is, the leading one of components 4 is positioned at the component suction position P. As described above, the automatic setting of the component packaging tape 2 with respect to the tape feeder 90 is terminated.

### (Effects due to configuration of exemplary embodiment)

According to the above-described automatic tape processing apparatus 110, it is possible to automatically perform the processes of controlling the feed device 120 and the separation device 150 to sequentially position the respective cutting target portions Q1 and Q2 of the carrier tape 21 and the top tape 22 at the cutting position Lc based on detection signals from the detection device 140, and controlling the cutting device 160 to sequentially cut the respective cutting target portions Q1 and Q2 of the carrier tape 21 and the top tape 22. Thus, it is not necessary to perform a tape cutting operation by an operator, and thus, it is possible to reduce a workload of the operator. Further, since the processes do not rely on the degree of skill of the operator, it is possible to improve efficiency when setting the component packaging tape 2 to the tape feeder 90.

Further, since there is provided the guide device 130 that performs guidance with reference to the upper surface when conveying the component packaging tape 2 along the conveyance path 121, it is possible to convey the component packaging tape 2 with a high accuracy, and to improve the cutting accuracy of the top tape 22 and the carrier tape 21. Further, since there is provided the transfer device 170 that holds the component packaging tape 2 conveyed after cut by the cutting device 160 and transfers the component packaging tape 2 to the automatic tape loading device, it is possible to further reduce the workload of the operator. Further, according to the automatic tape setting apparatus 1 including the automatic tape processing apparatus 110, it is possible to automatically perform all the processing of the tip of the component packaging tape 2 and the setting of the component packaging tape 2 to the tape feeder 90, and thus, it is possible to remarkably reduce the workload of the operator, and to set the component 4 in a suppliable state in a short period of time.

### Reference Signs List

1: AUTOMATIC TAPE SETTING APPARATUS, 2: COMPONENT PACKAGING TAPE, 3: TAPE REEL, 21: CARRIER TAPE, 22: TOP TAPE, 40: TAPE CONVEYANCE DEVICE, 70: TOP TAPE LOADING DEVICE, 90: TAPE FEEDER, 110: AUTOMATIC TAPE PROCESSING APPARATUS, 120: FEED DEVICE, 121: CONVEYANCE PATH, 130: GUIDE DEVICE, 131: PRESSING MEMBER, 132: CONTACT MEMBER, 140: DETECTION DEVICE, 150: SEPARATION DEVICE, 151: SCRAPER, 160: CUTTING DEVICE, 161: CUTTER, 170: TRANSFER DEVICE

## Claims

1. An automatic tape processing apparatus (110) that automatically processes a component packaging tape (2) which is wound on a tape reel (3) mounted in a tape feeder (90) and a top tape (22) of which is attached on an upper surface side of a carrier tape (21) having cavities (24) accommodating a component (4) at a predetermined pitch such that a tip of the top tape (22) protrudes by a predetermined protrusion length with reference to a tip of the carrier tape (21), comprising:
a feed device (120) that conveys the component packaging tape (2) along a conveyance path (121);
a detection device (140) that detects the presence or absence of the component (4) accommodated in the cavity (24) of the component packaging tape (2) conveyed along the conveyance path (121) at a detection position (Ld) provided in the conveyance path (121);
a separation device (150) that separates the top tape (22) from the component packaging tape (2) conveyed along the conveyance path (121);
a cutting device (160) that cuts respective cutting target portions (Q1, Q2) of the carrier tape (21) and the top tape (22) at a cutting position (Lc) provided in the conveyance path (121); and
a control device (100) that controls respective operations of the feed device (120), the separation device (150), and the cutting device (160),
wherein the control device (100) includes
positioning control means for controlling the feed device (120) and the separation device (150) based on a detection signal from the detection device (140) to sequentially position the respective cutting target portions (Q1, Q2) of the carrier tape (21) and the top tape (22) at the cutting position (Lc), and
cutting control means for controlling the cutting device (160) to sequentially cut the respective cutting target portions (Q1, Q2) of the carrier tape (21) and the top tape (22).

2. The automatic tape processing apparatus (110) according to claim 1, further comprising:
a guide device (130) that includes a pressing member (131) that presses the component packaging tape (2) conveyed along the conveyance path (121) from a lower surface thereof, and a contact member (132) with which an upper surface of the pressed component packaging tape (2) is in contact, and guides the component packaging tape (3) with reference to the upper surface when conveying the component packaging tape (2) along the conveyance path (121).

3. The automatic tape processing apparatus (110) according to claim 1 or 2, further comprising:
a transfer device (170) that holds the component packaging tape (2) conveyed after cut by the cutting device (160) and transfers the component packaging tape (2) to an automatic tape loading device that automatically loads the component packaging tape (2) to the tape feeder (90),
wherein the control device (100) includes
holding control means for lowering the transfer device (170) that is in a lifted state in advance, and causes the transfer device (170) to hold the conveyed component packaging tape (2); and
transfer control means for removing the component packaging tape (2) from the conveyance path (121), causing the transfer device (170) to move closer to the automatic tape loading device side so that a tape exiting port (171b) of the transfer device (170) is aligned with a tape inserting port of the automatic tape loading device, and convey-supplying the component packaging tape (2) from the tape exiting port (171b) to the tape inserting port for transfer.

4. The automatic tape processing apparatus (110) according to any one of claims 1 to 3,
wherein the positioning control means causes, when the transfer device (170) is lowered to convey the component packaging tape (2), a protruding portion (22a) of the top tape (22) cut by the cutting device (160) to protrude from the cutting position (Lc) so that the protruding portion (22a) of the top tape (22) is folded back onto a rear surface side of the tip of the carrier tape (21).

5. The automatic tape processing apparatus (110) according to any one of claims 1 to 4, wherein the control device (100) includes cutting target portion calculating means for calculating the cutting target portion (Q1) of the carrier tape (21) from a predetermined distance from the tip of the carrier tape (21) to the component in the forefront and a distance between the detection position (Ld) and the cutting position (Lc), based on a component presence signal transmitted when the detection device (140) detects that the cavity (24) where the component (4) is not accommodated transitions to the cavity (24) where the component (4) is accommodated, and
wherein after the component presence signal is transmitted, the positioning control means conveys the component packaging tape (2) by the distance between the detection position (Ld) and the cutting position (Lc) to position the cutting target portion (Q1) of the carrier tape (21) at the cutting position (Q1), and then, conveys the component packaging tape (2) by the predetermined protrusion length of the top tape (22) to position the cutting target portion (Q2) of the top tape (22) at the cutting position (Lc).

6. An automatic tape setting apparatus (1) that automatically sets a component packaging tape (2) to a tape feeder (90) that separates a top tape (22) from a carrier tape (21) in a first tape holder (95) and feeds the separated top tape (22) from the first tape holder (95) to a second tape holder (98) along a predetermined transfer path (121), comprising:
the automatic tape processing apparatus (110) according to any one of claims 1 to 5, which automatically processes a tip of the top tape (22) of the component packaging tape (2) wound on a tape reel (3) mounted in the tape feeder (90) to protrude by a predetermined protrusion length with reference to a tip of the carrier tape (21); and
an automatic tape loading device that conveys the component packaging tape (2) that is processed and transferred by the automatic tape processing apparatus (110) to the first tape holder (95), connects a tentative tape formed in a shape that resembles the transfer path (121) to the top tape (22) separated in the first tape holder (95), transfers the tentative tape to the tape feeder (90), and conveys the carrier tape (21) from which the top tape (22) is separated to a component supply position of the tape feeder (90).

7. The automatic tape setting apparatus (1) according to claim 6,
wherein when the component packaging tape (2) in which a protruding portion (22a) of the top tape (22) is folded back onto a rear surface side of the tip of the carrier tape (21) is transferred from the automatic tape processing apparatus (110), the automatic tape loading device conveys the component packaging tape (2) to cause the protruding portion (22a) of the top tape to protrude from a tip portion of the tape feeder (90), and reversely conveys the component packaging tape (2) to return the folded-back state of the protruding portion (22a) of the top tape (22) to an original state.

## Patentansprüche

1. Automatische Band-Verarbeitungsvorrichtung (110), die automatisch ein Bauteilband (2) verarbeitet, das auf eine Bandspule (3) aufgewickelt ist, die in einer Band-Zuführeinrichtung (90) installiert ist, und dessen oberes Band (22) an der Seite einer oberen Fläche eines Trägerbandes (21), das Hohlräume (24), die ein Bauteil (4) aufnehmen, in einem vorgegebenen Abstand aufweist, so angebracht wird, dass ein vorderes Ende des oberen Bandes (22) um eine vorgegebene Vorsteh-Länge in Bezug auf ein vorderes Ende des Trägerbandes (21) vorsteht, wobei sie umfasst:
eine Zuführeinrichtung (120), die das Bauteilband (2) auf einem Transportweg (121) transportiert;
eine Erfassungseinrichtung (140), die das Vorhandensein oder Nichtvorhandensein des Bauteils (4), das in dem Hohlraum (24) des auf dem Transportweg (121) transportierten Bauteilbandes (2) aufgenommen ist, an einer Erfassungs-Position (Ld) erfasst, die sich auf dem Transportweg (121) befindet;
eine Trenneinrichtung (150), die das obere Band (22) von dem auf dem Transportweg (121) transportierten Bauteilband (2) trennt;
eine Schneideinrichtung (160), die jeweilige Schneid-Abschnitte (Q1, Q2) des Trägerbandes (21) und des oberen Bandes (22) an einer Schneid-Position (Lc) schneidet, die sich auf dem Transportweg (121) befindet; und
eine Steuerungseinrichtung (100), die jeweilige Funktionen der Zuführeinrichtung (120), der Trenneinrichtung (150) und der Schneideinrichtung (160) steuert,
wobei die Steuerungseinrichtung (100) enthält:
ein Positionier-Steuerungsmittel, mit dem die Zuführeinrichtung (120) und die Trenneinrichtung (150) auf Basis eines Erfassungssignals von der Erfassungseinrichtung (140) so gesteuert werden, dass die jeweiligen Schneid-Abschnitte (Q1, Q2) des Trägerbandes (21) und des oberen Bandes (22) sequenziell an der Schneid-Position (Lc) positioniert werden, sowie
ein Schneid-Steuerungsmittel, mit dem die Schneideinrichtung (160) so gesteuert wird, dass die jeweiligen Schneid-Abschnitte (Q1, Q2) des Trägerbandes (21) und des oberen Bandes (22) sequenziell geschnitten werden.

2. Automatische Band-Verarbeitungsvorrichtung (110) nach Anspruch 1, die des Weiteren umfasst:
eine Führungseinrichtung (130), die ein Press-Element (131), das das auf dem Transportweg (121) transportierte Bauteilband (2) von einer Unterseite desselben her presst, sowie ein Kontakt-Element (132) enthält, mit dem eine Oberseite des gepressten Bauteilbandes (2) in Kontakt ist, und die das Bauteilband (2) beim Transport des Bauteilbandes (2) auf dem Transportweg (121) in Bezug auf die Oberseite führt.

3. Automatische Band-Verarbeitungsvorrichtung (110) nach Anspruch 1 oder 2, die des Weiteren umfasst:
eine Überführungseinrichtung (170), die das transportierte Bauteilband (2) aufnimmt, nachdem es durch die Schneideinrichtung (160) geschnitten worden ist, und das Bauteilband (2) zu einer automatischen Band-Einlegeeinrichtung überführt, die das Bauteilband (2) automatisch in die Band-Zuführeinrichtung (90) einlegt,
wobei die Steuerungseinrichtung (100) enthält:
ein Aufnahme-Steuerungsmittel, mit dem die Überführungseinrichtung (170), die sich zuvor in einem angehobenen Zustand befindet, abgesenkt wird und die Überführungseinrichtung (170) veranlasst wird, das transportierte Bauteilband (2) aufzunehmen; sowie
ein Überführungs-Steuerungsmittel, mit dem das Bauteilband (2) von dem Transportweg (121) entfernt wird, die Überführungseinrichtung (170) veranlasst wird, sich näher zur Seite der automatischen Band-Einlegeeinrichtung zu bewegen, so dass eine Band-Austrittsöffnung (171b) der Überführungseinrichtung (170) auf eine Band-Einführöffnung der automatischen Band-Einlegeeinrichtung ausgerichtet wird, und mit dem das Bauteilband (2) von der Band-Austrittsöffnung (171b) zur Überführung zu der Band-Einführöffnung zuführend transportiert wird.

4. Automatische Band-Verarbeitungsvorrichtung (110) nach einem der Ansprüche 1 bis 3,
wobei das Positionier-Steuerungsmittel veranlasst, dass, wenn die Überführungseinrichtung (170) abgesenkt wird, um das Bauteilband (2) zu transportieren, ein durch die Schneideinrichtung (160) geschnittener vorstehender Abschnitt (22a) von der Schneid-Position (Lc) vorsteht, so dass der vorstehende Abschnitt (22a) des oberen Bandes (22) auf eine Seite einer hinteren Fläche des vorderen Endes des Trägerbandes (21) umgefaltet wird.

5. Automatische Band-Verarbeitungsvorrichtung (110) nach einem der Ansprüche 1 bis 4,
wobei die Steuerungseinrichtung (100) ein Mittel zum Berechnen eines Schneid-Abschnitts enthält, mit dem der Schneid-Abschnitt (Q1) des Trägerbandes (21) aus einer vorgegebenen Entfernung von dem vorderen Ende des Trägerbandes (21) zu dem vordersten Bauteil sowie einer Entfernung zwischen der Erfassungs-Position (Ld) und der Schneid-Position (Lc) auf Basis eines Signals über das Vorhandensein eines Bauteils berechnet wird, das gesendet wird, wenn die Erfassungseinrichtung (140) erfasst, dass der Hohlraum (24), in dem das Bauteil (4) nicht aufgenommen ist, zu dem Hohlraum (24) übergeht, in dem das Bauteil (4) aufgenommen ist, und
wobei, nachdem das Signal über das Vorhandensein eines Bauteils gesendet worden ist, das Positionier-Steuerungsmittel das Bauteilband (2) über die Entfernung zwischen der Erfassungs-Position (Ld) und der Schneid-Position (Lc) transportiert, um den Schneid-Abschnitt (Q1) des Trägerbandes (21) an der Schneid-Position (Lc) zu positionieren, und dann das Bauteilband (2) um die vorgegebene Vorsteh-Länge des oberen Bandes (22) transportiert, um den Schneid-Abschnitt (Q2) des oberen Bandes (22) an der Schneid-Position (Lc) zu positionieren.

6. Automatische Band-Einsetzvorrichtung (1), die ein Bauteilband (2) automatisch in eine Band-Zuführeinrichtung (90) einsetzt, die ein oberes Band (22) von einem Trägerband (21) in einer ersten Band-Aufnahmeeinrichtung (95) trennt und das getrennte obere Band (22) von der ersten Band-Aufnahmeeinrichtung (95) auf einem vorgegebenen Überführungsweg (121) zu einer zweiten Band-Aufnahmeeinrichtung (98) zuführt, wobei sie umfasst:
die automatische Band-Verarbeitungsvorrichtung (110) nach einem der Ansprüche 1 bis 5, die ein vorderes Ende des oberen Bandes (22) des auf eine in der Band-Zuführeinrichtung (90) installierten Bandspule (3) aufgewickelten Bauteilbandes (2) so verarbeitet, dass es um eine vorgegebene Vorsteh-Länge in Bezug auf ein vorderes Ende des Trägerbandes (21) vorsteht; und
eine automatische Band-Einlegeeinrichtung, die das durch die automatische Band-Verarbeitungsvorrichtung (110) verarbeitete und überführte Bauteilband (2) zu der ersten Band-Aufnahmeeinrichtung (95) transportiert, ein Hilfsband, das in einer Form ausgebildet ist, die dem Überführungsweg (121) gleicht, mit dem in der ersten Band-Aufnahmeeinrichtung (95) getrennten oberen Band (22) verbindet, das Hilfsband zu der Band-Zuführeinrichtung (90) überführt und das Trägerband (21), von dem das obere Band (22) getrennt ist, zu einer Bauteil-Zuführposition der Band-Zuführeinrichtung (90) transportiert.

7. Automatische Band-Einsetzvorrichtung (1) nach Anspruch 6,
wobei, wenn das Bauteilband (2), bei dem ein vorstehender Abschnitt (22a) des oberen Bandes (22) auf die Seite einer hinteren Fläche des vorderen Endes des Trägerbandes (21) umgefaltet ist, von der automatischen Band-Verarbeitungsvorrichtung (110) überführt wird, die automatische Band-Einlegeeinrichtung das Bauteilband (2) so transportiert, dass veranlasst wird, dass der vorstehende Abschnitt (22a) des oberen Bandes von einem vorderen Abschnitt der Band-Zuführeinrichtung (90) vorsteht, und das Bauteilband (2) umgekehrt transportiert, um den vorstehenden Abschnitt (22a) des oberen Bandes (22) von dem umgefalteten Zustand wieder in einen ursprünglichen Zustand zurückzuversetzen.

## Revendications

1. Appareil de traitement de bande automatique (110) qui traite automatiquement une bande d'emballage de composant (2) qui est enroulée sur une bobine de bande (3) montée dans un dispositif d'alimentation de bande (90) et dont une bande supérieure (22) est fixée sur un côté de surface supérieure d'une bande de transport (21) ayant des cavités (24) logeant un composant (4) à un pas prédéterminé de sorte qu'une pointe de la bande supérieure (22) fait saillie d'une longueur de saillie prédéterminée en référence à une pointe de la bande de transport (21), comprenant:
un dispositif d'alimentation (120) qui transporte le ruban d'emballage de composant (2) le long d'un chemin de transport (121);
un dispositif de détection (140) qui détecte la présence ou l'absence du composant (4) logé dans la cavité (24) de la bande d'emballage de composant (2) transporté le long du chemin de transport (121) à une position de détection (Ld) prévue dans le chemin de transport(121);
un dispositif de séparation (120) qui transporte le ruban supérieur (22) depuis la bande d'emballage de composant (2) le long d'un chemin de transport (121);
un dispositif de découpe (160) qui découpe des parties cibles de découpe respectives (Q1, Q2) de la bande de transport (21) et de la bande supérieure (22) à une position de découpe (Lc) prévue dans le chemin de transport (121); et
un dispositif de commande (100) qui commande les opérations respectives du dispositif d'alimentation (120), du dispositif de séparation (150) et du dispositif de découpe (160),
dans lequel le dispositif de commande (100) comprend
des moyens de commande de positionnement pour commander le dispositif d'alimentation (120) et le dispositif de séparation (150) sur la base d'un signal de détection provenant du dispositif de détection (140) pour positionner séquentiellement les parties cibles de découpe respectives (Q1, Q2) de la bande de transport (21) et de la bande supérieure (22) à la position de coupe (Lc), et
des moyens de commande de découpe pour commander le dispositif de découpe (160) pour découper séquentiellement les parties de cible de découpe respectives (Q1, Q2) de la bande de transport (21) et de la bande supérieure (22).

2. Appareil de traitement de bande automatique (110), selon la revendication 1, comprenant en outre:
un dispositif de guidage (130) qui comprend un élément de pression (131) qui comprime la bande d'emballage de composant (2) transportée le long du chemin de transport (121) à partir d'une surface inférieure de celui-ci, et un élément de contact (132) avec lequel une surface supérieure de la bande d'emballage de composant comprimée (2) est en contact, et guide la bande d'emballage de composant (3) en référence à la surface supérieure lors du transport de la bande d'emballage de composant (2) le long du chemin de transport (121).

3. Appareil de traitement de bande automatique (110), selon les revendications 1 ou 2, comprenant en outre:
un dispositif de transfert (170) qui retient la bande d'emballage de composant (2) transportée après découpe par le dispositif de coupe (160) et transfère la bande d'emballage de composant (2) à un dispositif de chargement de bande automatique qui charge automatiquement la bande d'emballage de composant (2) vers le dispositif d'alimentation de bande (90),
dans lequel le dispositif de commande (100) comprend
des moyens de commande de maintien pour abaisser le dispositif de transfert (170) qui est en état de levage par avance, et amène le dispositif de transfert (170) à maintenir la bande d'emballage de composant transportée (2); et
des moyens de commande de transfert pour retirer la bande d'emballage de composant (2) du chemin de transport (121), amenant le dispositif de transfert (170) à se rapprocher du côté du dispositif de chargement de bande automatique de sorte qu'un port de sortie de bande (171b) du dispositif de transfert (170) est aligné avec un port d'insertion de bande du dispositif de chargement de bande automatique et transmet la bande d'emballage de composant (2) depuis le port de sortie de bande (171b) vers le port d'insertion de bande en vue du transfert.

4. Appareil de traitement de bande automatique (110), selon les revendications 1 à 3,
dans lequel les moyens de commande de positionnement conduisent, lorsque le dispositif de transfert (170) est abaissé pour transporter la bande d'emballage de composant (2), une partie en saillie (22a) de la bande supérieure (22) découpée par le dispositif de coupe (160) à faire saillie depuis la position de coupe (Lc) de sorte que la partie en saillie (22a) de la bande supérieure (22) est repliée sur le côté de la face arrière de la pointe de la bande de transport (21).

5. Appareil de traitement de bande automatique (110), selon l'une quelconque des revendications 1 à 4,
dans lequel le dispositif de commande (100) comprend des moyens de calcul de la partie cible de découpe pour calculer la partie cible de découpe (Q1) de la bande de transport (21) à partir d'une distance prédéterminée par rapport à la pointe de la bande de transport (21) jusqu'au composant situé à l'avant et une distance séparant la position de détection (Ld) et la position de découpe (Lc), sur la base d'un signal de présence de composant transmis lorsque le dispositif de détection (140) détecte que la cavité (24) où le composant (4) n'est pas logé, effectue une transition vers la cavité (24) où le composant (4) est logé, et
dans lequel, après l'émission du signal de présence de composant, les moyens de commande de positionnement acheminent la bande d'emballage de composant (2) sur la distance séparant la position de détection (Ld) et la position de découpe (Lc) pour positionner la partie cible de découpe (Q1) de la bande de transport (2) à la position de découpe (Q1), et ensuite acheminent la bande d'emballage de composant (2) sur la longueur saillante prédéterminée de la bande supérieure (22) pour positionner la partie cible de découpe (Q2) de la bande supérieure (22) à la position de coupe (Lc).

6. Appareil de réglage de bande automatique (1) qui règle automatiquement une bande d'emballage de composant (2) sur un dispositif d'alimentation de bande (90) qui sépare une bande supérieure (22) d'une bande de transport (21) dans un premier support de bande (95) et alimente la bande supérieur séparée (22) depuis le premier support de bande (95) vers un second support de bande (98) le long d'un chemin de transfert prédéterminé (121), comprenant:
l'appareil de traitement de bande automatique (110) selon l'une quelconque des revendications 1 à 5, qui traite automatiquement une pointe de la bande supérieure (22) de la bande d'emballage de composant (2) enroulée sur une bobine de bande (3) montée dans le dispositif d'alimentation de bande (90) pour faire saillie d'une longueur de protrusion prédéterminée en référence à une pointe de la bande de transport (21); et
un dispositif de chargement de bande automatique qui transmet la bande d'emballage composant (2) qui est traitée et transférée par l'appareil de traitement de bande automatique (110) au premier support de bande (95), relie une bande provisoire de forme ressemblant au chemin de transfert (121) sur la bande supérieure (22) séparée dans le premier support de bande (95), transfère la bande provisoire sur le dispositif d'alimentation de bande (90) et transmet la bande de transport (21) à partir de laquelle la bande supérieure (22) est séparée vers une position d'alimentation de composant du dispositif d'alimentation de bande (90).

7. Appareil de réglage de bande automatique (1) selon la revendication 6, dans lequel, lorsque la bande d'emballage de composant (2), dans laquelle une partie saillante (22a) de la bande supérieure (22) est repliée sur un côté de surface arrière de la pointe de la bande de transport (21), est transférée depuis l'appareil de traitement de bande automatique (110), le dispositif de chargement de bande automatique transporte la bande d'emballage de composant (2) pour faire en sorte que la partie saillante (22a) de la bande supérieure dépasse d'une partie de la pointe du dispositif d'alimentation de bande (90), et inversement achemine la bande d'emballage de composant (2) pour ramener l'état replié de la partie saillante (22a) de la bande supérieure (22) à un état d'origine.
